# EUROPEAN PATENT APPLICATION

(11) **EP 4 676 203 A1**
(43) Date of publication of application: **07.01.2026**
(21) Application number: 25187383.2
(22) Date of filing: 03.07.2025
(51) Int. Cl.: H10K 59/122, H10K 59/35, H10K 59/80, H10K 59/12

(54) **DISPLAY DEVICE, ELECTRONIC DEVICE INCLUDING DISPLAY DEVICE, AND METHOD OF PROVIDING THE SAME**

(30) Priority: 05.07.2024 KR 20240089021
(71) Applicant: Samsung Display Co., Ltd., Yongin-si, Gyeonggi-do 17113 (KR)
(72) Inventor: SUNG, Woo Yong, Yongin-si (KR); YANG, Hee Jun, Yongin-si (KR)
(74) Representative: Marks & Clerk LLP

(57) **Abstract**

A display device includes a pixel-defining layer in which first openings are defined corresponding to an emission area, a bank which is on the pixel-defining layer and defines second openings overlapping the first openings, light emission structures respectively in the first openings, including a first emission structure having a first light-emitting element and a first element inorganic pattern, a second emission structure having a second light-emitting element and a second element inorganic pattern, each of the first and second element inorganic patterns having a thickness in a respective first opening, the thickness of the first and second element inorganic patterns being different from each other, and a total height of the first emission structure is equal to a total height of the second emission structure, and an organic encapsulation layer on the light emission structures.

## Description

### BACKGROUND

### 1. Field

The present disclosure relates to a display device, an electronic device including the display device, and a method of fabricating (or providing) the same.

### 2. Description of the Related Art

As the information-oriented society evolves, various demands for display devices are ever increasing. For example, display devices are being employed by a variety of electronic devices such as smart phones, digital cameras, laptop computers, navigation devices, and smart televisions. Display devices may be flat-panel display devices such as a liquid-crystal display device, a field emission display device, and an organic light-emitting display device. Among such flat panel display devices, a light-emitting display device includes a light-emitting element which can emit light on its own, so that each of the pixels of the display panel can emit light by themselves. Accordingly, a light-emitting display device can display images without a backlight unit which supplies light to the display panel.

### SUMMARY

As various electronic devices have developed, the demand for high-resolution display devices is increasing. Since high-resolution display devices require high pixel density, the spacing between light-emitting elements in each emission area may be narrowed. Therefore, a high-resolution display device can be formed via a patterning process which forms individual pixels rather than a process using a fine metal mask.

Aspects of the present disclosure provide a display device in which separate emission structures can be formed in emission areas without a separate fine metal mask and an organic encapsulation layer can spread evenly.

It should be noted that objects of the present disclosure are not limited to the above-mentioned object, and other objects of the present disclosure will be apparent to those skilled in the art from the following descriptions.

The details of one or more embodiments of the subject matter described in this specification are set forth in the accompanying drawings and the description below.

In an embodiment of the disclosure, a display device includes a substrate including an emission area and a non-emission area, a first emission structure disposed on the emission area of the substrate and including a first light-emitting element and a first element inorganic layer covering the first light-emitting element, a pixel-defining layer disposed on the non-emission area of the substrate and defining a first opening, a bank structure disposed on the pixel-defining layer, defining a second opening and including a first bank layer and a second bank layer, a second emission structure spaced apart from the first emission structure in a direction parallel to the substrate and including a second light-emitting element and a second element inorganic layer, and an organic encapsulation layer disposed on the first emission structure and the second emission structure, where a height of the first element inorganic layer is different from a height of the second element inorganic layer in the first opening, and a height of the first emission structure is equal to a height of the second emission structure in the first opening.

In an embodiment, the height of the first element inorganic layer may be lower than the height of the second element inorganic layer in the first opening.

In an embodiment, a film density of the first element inorganic layer may be higher than a film density of the second element inorganic layer.

In an embodiment, the height of the first element inorganic layer and the height of the second element inorganic layer may range from about 1.05 micrometers to about 1.15 micrometers.

In an embodiment, a moisture permeability of the first element inorganic layer may be equal to a moisture permeability of the second element inorganic layer.

In an embodiment, the first element inorganic layer may include a first surface in contact with the organic encapsulation layer, and the second element inorganic layer includes a second surface in contact with the organic encapsulation layer, and where the first surface and the second surface may be located on a same line in a direction parallel to the substrate in the first opening.

In an embodiment, the first surface and the second surface may be spaced apart from each other with the organic encapsulation layer therebetween in the non-emission area, and the first surface and the second surface are located on the same line in the direction parallel to the substrate in the non-emission area.

In an embodiment, the display device may further include a third emission structure spaced apart from the second emission structure in an opposite direction in which the first emission structure is located, where the third emission structure may include a third light-emitting element and a third element inorganic layer, and where the height of the first emission structure, the height of the second emission structure and a height of the third emission structure may be all equal.

In an embodiment, the height of the third element inorganic layer may be higher than the height of the first element inorganic layer and the height of the second element inorganic layer.

In an embodiment, the third element inorganic layer may include a third surface in contact with the organic encapsulation layer, and the first surface, the second surface and the third surface may be located on the same line in the direction parallel to the substrate in the first opening.

In an embodiment, the first emission structure, the second emission structure and the third emission structure may emit light of different colors.

In an embodiment, the first light-emitting element may include a first emissive layer and a first cathode electrode, the second light-emitting element may include a second emissive layer and a second cathode electrode, and where a height of the first emissive layer may be different from a height of the second emissive layer.

In an embodiment, the height of the first emissive layer may be higher than the height of the second emissive layer.

In an embodiment, the first emission structure may further include a first organic pattern including a same material as the first emissive layer and disposed on the second bank layer, where the second emission structure may further include a second organic pattern including a same material as the second emissive layer and disposed on the second bank layer, and where a height of the first organic pattern may be higher than a height of the second organic pattern.

In an embodiment, the second bank layer may include a tip which protrudes toward the first opening from a side surface of the first bank layer.

In an embodiment of the disclosure, an electronic device includes a display panel including a display area including a substrate including an emission area and a non-emission area, and a non-display area surrounding the display area, a first emission structure disposed on the emission area of the substrate and including a first light-emitting element and a first element inorganic layer covering the first light-emitting element, a pixel-defining layer disposed on the non-emission area of the substrate and defining a first opening, a bank structure disposed on the pixel-defining layer, defining a second opening and including a first bank layer and a second bank layer, a second emission structure spaced apart from the first emission structure in a direction parallel to the substrate and including a second light-emitting element and a second element inorganic layer, and an organic encapsulation layer disposed on the first emission structure and the second emission structure, where a height of the first element inorganic layer is different from a height of the second element inorganic layer in the first opening, and a height of the first emission structure is equal to a height of the second emission structure in the first opening.

In an embodiment of the disclosure, there is provided a method of fabricating a display device, wherein the method includes forming a first anode electrode and a second anode electrode on a substrate, and a bank structure covering the first anode electrode and the second anode electrode, etching a part of the bank structure to expose the first anode electrode and the second anode electrode, forming a first emission structure entirely on the first anode electrode, the second anode electrode and the bank structure, and etching a part of the first emission structure to expose the second anode electrode, and forming a second emission structure on the first emission structure, the second anode electrode and the bank structure, and etching a part of the second emission structure, where a height of the first emission structure is equal to a height of the second emission structure.

In an embodiment, the first emission structure includes a first emissive layer and a first element inorganic layer, and the second emission structure includes a second emissive layer and a second element inorganic layer, and where a process of forming the first emissive layer and the second emissive layer may be a photo pattern process.

In an embodiment, a height of the first emissive layer may be higher than a height of the second emissive layer, and a height of the first element inorganic layer may be lower than a height of the second element inorganic layer.

In an embodiment, the height of the first element inorganic layer and the height of the second element inorganic layer are adjusted according to the height of the first emissive layer and the height of the second emissive layer.

At least some of the above and other features of the invention are set out in the claims.

According to an embodiment of the present disclosure, separate emission structures can be formed in emission areas of a display device without a separate fine metal mask, and an organic encapsulation layer can spread more evenly.

It should be noted that effects of the present disclosure are not limited to those described above and other effects of the present disclosure will be apparent to those skilled in the art from the following descriptions.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view of a display device according to an embodiment of the present disclosure.
FIG. 2 is a cross-sectional view of the display device of FIG. 1 seen from the side of the display device.
FIG. 3 is a plan view showing pixels located in the display area of FIG. 2.
FIG. 4 is a cross-sectional view taken along line X1 - X1' of FIG. 3.
FIG. 5 is an enlarged cross-sectional view of a display element layer in the first emission area in FIG. 4.
FIG. 6 is an enlarged cross-sectional view of the display element layer in the non-emission area located between the first emission area and the second emission area in FIG. 4.
FIG. 7 is an enlarged cross-sectional view of the display element layer in the non-emission area located between the second emission area and the third emission area in FIG. 4.
FIGS. 8 to 18 are cross-sectional views for illustrating a method of fabricating (or providing) the display element layer in FIG. 4.
FIG. 19 is a perspective view showing an electronic device employing the display device according to the embodiment of the present disclosure.
FIG. 20 is a block diagram illustrating an electronic device according to an embodiment of the present disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout. Within the Figures and the text of the disclosure, a reference number indicating a singular form of an element may also be used to reference a plurality of the element.

It will be understood that when an element is referred to as being related to another element such as being "on" another element, it can be directly on the other element or intervening elements may be present therebetween. In contrast, when an element is referred to as being related to another element such as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the present disclosure will be described in detail with reference to the accompanying drawings.

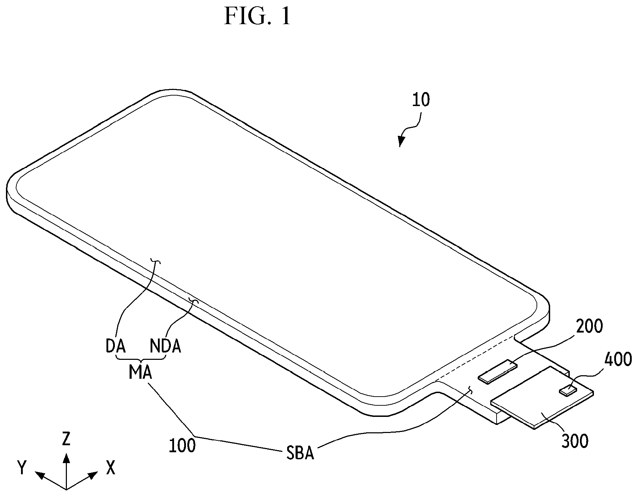

FIG. 1 is a perspective view of a display device 10 according to an embodiment of the present disclosure.

Referring to FIG. 1, the display device 10 displays a moving image or a still image. A display device 10 may refer to any electronic device which provides a display screen or a component of an electronic device which provides a display screen of the electronic device. For example, the display device 10 may include (or be a component of) a television set, a laptop computer, a monitor, an electronic billboard, the Internet of Things devices, a mobile phone, a smart phone, a tablet personal computer (PC), an electronic watch, a smart watch, a watch phone, a head-mounted display device, a mobile communications terminal, an electronic notebook, an electronic book, a portable multimedia player (PMP), a navigation device, a game console and a digital camera, a camcorder, etc.

In FIG. 1, a first direction (x-axis direction), a second direction (y-axis direction) and a third direction (z-axis direction) are defined. The first direction (x-axis direction) and the second direction (y-axis direction) cross each other and may be perpendicular to each other, the first direction (x-axis direction) and the third direction (z-axis direction) cross each other and may be perpendicular to each other, and the second direction (y-axis direction) and the third direction (z-axis direction) cross each other and may be perpendicular to each other. The first direction (x-axis direction) may refer to the horizontal direction in the drawings, the second direction (y-axis direction) may refer to the vertical direction in the drawings, and the third direction (z-axis direction) may refer to the up-and-down direction, e.g., the thickness direction in the drawings. As used herein, a direction may refer to the direction indicated by the arrow as well as the opposite direction, unless specifically stated otherwise. If it is necessary to discern between such two opposite directions, one of the two directions may be referred to as "one side in the direction," while the other direction may be referred to as "the opposite side in the direction". In FIG. 1, the side indicated by an arrow indicative of a direction is referred to as one side in the direction, while the opposite side is referred to as the opposite side in the direction.

In the following description of the surfaces of the display device 10, the surface facing one side where images are displayed, e.g., the side indicated by the arrow in the third direction (z-axis direction) will be referred to as the upper surface, while the opposite surface will be referred to as the lower surface, for convenience of illustration. It should be understood, however, that the present disclosure is not limited thereto. The surfaces and the opposite surface of each of the elements may be referred to as a front surface and a rear surface, respectively, or may be referred to as a first surface and a second surface, respectively. In addition, in the description of relative positions of the elements of the display device 10, one side in the third direction (z-axis direction) may be referred to as the upper side while the opposite side in the third direction (z-axis direction) may be referred to as the lower side.

The shape (e.g., a planar shape such as in an X-Y plane) of the display device 10 according to the embodiment may be modified in a variety of ways. For example, the display device 10 may have shapes such as a rectangle with longer lateral sides, a rectangle with longer vertical sides, a square, a quadrangle with rounded corners (vertices), other polygons, a circle, etc.

The display device 10 may include a display panel 100, a display driver 200, a circuit board 300 and a touch driver 400.

According to the embodiment of the present disclosure, the display panel 100 may include a main area MA and a subsidiary area SBA. The main area MA may include the display area DA including pixels PX for displaying images, and the non-display area NDA which is adjacent to the display area DA such as being located around the display area DA. The main area MA and the subsidiary area SBA forming a total planar area of the display device 10 may include a flexible material which can be bent, folded, or rolled. As used herein, the subsidiary area SBA may be considered a portion of the non-display area NDA.

In the display area DA, images can be displayed, light can be emitted, etc. In the non-display area NDA, images are not displayed, light is not emitted, etc. The display area DA may be referred to as an active area, while the non-display area NDA may also be referred to as an inactive area. The display area DA may generally occupy the center of the display device 10, that is, a planar area spaced apart from outer edges of the display device 10. The non-display area NDA may be defined as the edge of the main area MA of the display panel 100, where a boundary is defined between the non-display area NDA and the display area DA. The non-display area NDA may include lines (e.g., signal lines, conductive lines, transmission lines, etc.) which provide signals to the display area DA, and lines connecting the display driver 200 with the display area DA.

The subsidiary area SBA may be extended from one side of the main area MA. When the display device 10 is bent at the subsidiary area SBA, the subsidiary area SBA may overlap with the main area MA in the thickness direction (e.g., the third direction or z-axis direction). The subsidiary area SBA may include display pads connected to the display driver 200 and the circuit board 300. According to another embodiment, the subsidiary area SBA may be eliminated, and the display driver 200 and the display pads may be located in the non-display area NDA. In an embodiment, the display pads may be further connected (e.g., electrically) to pixels PX of the display area DA.

The display driver 200 according to the embodiment may output signals and voltages for driving the display panel 100. The display driver 200 may be implemented as an integrated circuit (IC) and may be attached on the display panel 100 by a chip-on-glass (COG) technique, a chip-on-plastic (COP) technique, or ultrasonic bonding. For example, the display driver 200 may be disposed in and connected to the display panel 100 at the subsidiary area SBA, and may overlap with the main area MA in the thickness direction as the display panel 100 includes the subsidiary area SBA which is bent. For another example, the display driver 200 may be mounted on an external component such as the circuit board 300.

According to the embodiment of the present disclosure, the circuit board 300 may be attached to the display panel 100 at the display pads of the display panel 100 using an anisotropic conductive film (ACF). The circuit board 300 may be electrically connected to the display pads. The circuit board 300 may be a flexible printed circuit board (FPCB), a printed circuit board (PCB), or a flexible film such as a chip-on-film (COF).

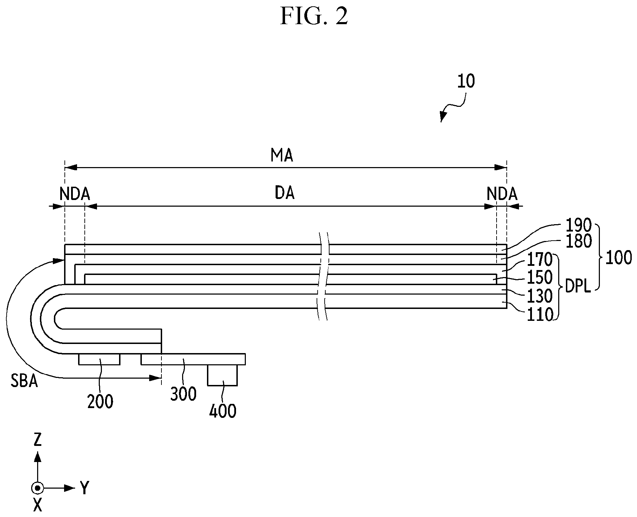

According to the embodiment, the touch driver 400 may be mounted on the circuit board 300. The touch driver 400 may be connected to a touch sensor layer 180 (see FIG. 2) of the display panel 100.

FIG. 2 is a cross-sectional view of the display device 10 of FIG. 1.

Referring to FIG. 2, the display panel 100 may include a display layer DPL, a touch sensor layer 180, and a color filter layer 190. The display layer DPL may include a substrate 110, a thin-film transistor layer 130, a display element layer 150, and a thin-film encapsulation layer 170.

The substrate 110 may be a base substrate or a base member. The substrate 110 may be a flexible substrate which can be bent, folded, or rolled. For example, the substrate 110 may include, but is not limited to, a polymer resin such as polyimide (PI). According to another embodiment, the substrate 110 may include a glass material or a metal material.

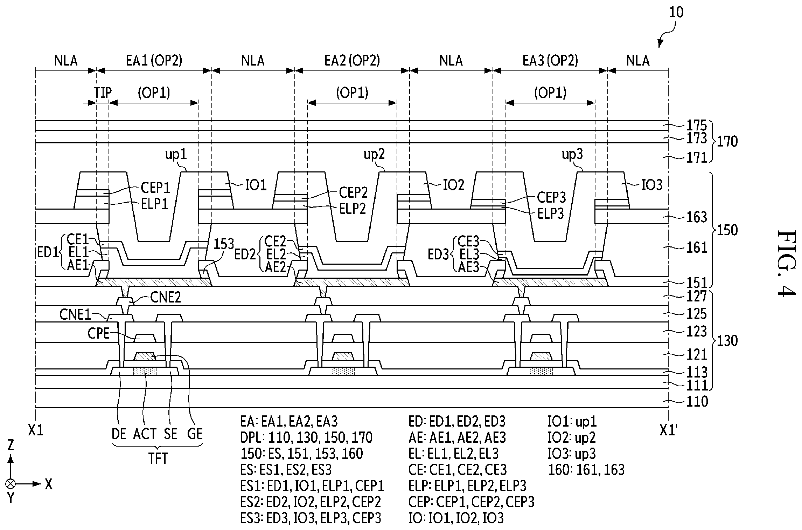

The thin-film transistor layer 130 as a circuit layer or a pixel circuit layer may be disposed on the substrate 110. The thin-film transistor layer 130 may be disposed in the display area DA, the non-display area NDA and the subsidiary area SBA. The thin-film transistor layer 130 may include a plurality of thin-film transistors TFT (see FIG. 4).

The display element layer 150 may be disposed on the thin-film transistor layer 130 and include a light emitting element as a display element. The display element layer 150 may be located in the display area DA. The display element layer 150 may include, but is not limited to, at least one of an organic light-emitting diode including an organic emissive layer, a quantum-dot light-emitting diode (quantum LED) including a quantum-dot emissive layer, an inorganic light-emitting diode (inorganic LED) including an inorganic semiconductor, and a micro light-emitting diode (micro LED).

The thin-film encapsulation layer 170 as an encapsulation layer may be disposed on the display element layer 150. The thin-film encapsulation layer 170 may be disposed in the display area DA and the non-display area NDA. The thin-film encapsulation layer 170 may cover the upper and side surfaces of the display element layer 150, and can protect the display element layer 150 from outside oxygen and moisture. The thin-film encapsulation layer 170 may include at least one inorganic film and at least one organic film for encapsulating the display element layer 150.

The touch sensor layer 180 as an input sensing layer may be disposed on the thin-film encapsulation layer 170. The touch sensor layer 180 may be located across the display area DA and the non-display area NDA. The touch sensor layer 180 may sense an external input from an input tool, such as touch from a body part of a user (e.g., a user's touch) by mutual (electrical) capacitance sensing or self-capacitance sensing.

The color filter layer 190 as a light control layer may be disposed on the touch sensor layer 180. The color filter layer 190 may be located in the display area DA and the non-display area NDA. The color filter layer 190 may absorb some of the light introduced from the outside of the display device 10 to reduce the reflection of external light by components or layers of the display device 10. Accordingly, the color filter layer 190 can prevent distortion of colors due to the reflection of external light.

Since the color filter layer 190 is disposed directly on the touch sensor layer 180, the display device 10 may require no separate substrate for the color filter layer 190. Therefore, the overall thickness of the display device 10 can be relatively small. The color filter layer 190 may be eliminated in some implementations.

As shown in FIG. 2, the display panel 100 may be bent to dispose a portion of the display panel 100 overlapping with the subsidiary area SBA. When a portion of the display panel 100 is bent, the display driver 200, the circuit board 300 and the touch driver 400 may overlap with the main area MA in the third direction (z-axis direction) as a thickness direction of the display device 10.

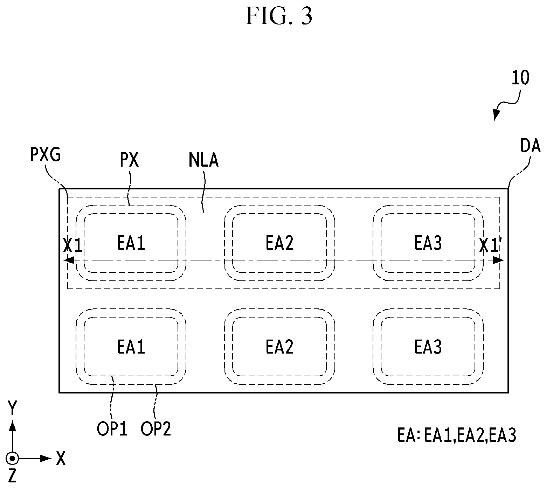

FIG. 3 is a plan view showing a layout of pixels PX located in the display area DA of FIG. 2.

Referring to FIG. 3, the display area DA according to the embodiment may include a light emission area provided in plural including emission areas EA such as the first to third emission areas EA1, EA2 and EA3 and a non-emission area NLA which is adjacent to each of the light emission areas. The non-emission area NLA may be located such that it surrounds the first to third emission areas EA1, EA2 and EA3.

The non-emission area NLA can block the light exiting from the first to third emission areas EA1, EA2 and EA3. Accordingly, the non-emission area NLA can help prevent the light exiting from the first to third emission areas EA1, EA2 and EA3 from being mixed.

The emission areas EA may include first emission areas EA1, second emission areas EA2 and third emission areas EA3, which emit light of different colors. Each of the first to third emission areas EA1, EA2 and EA3 may emit red, green or blue light. The colors of light emitted from the first to third emission areas EA1, EA2 and EA3 may vary depending on the type of light-emitting elements ED (see FIG. 4), which will be described later. For example, the first emission area EA1 may output light of a first color, e.g., red color, the second emission area EA2 may output light of a second color, e.g., green color, and the third emission area EA3 may output light of a third color, e.g., blue color. It should be understood, however, that the present disclosure is not limited thereto. Although the first to third emission areas EA1, EA2 and EA3 have the same size and shape in the drawings (e.g., a planar size and a planar shape in the X-Y plane), the present disclosure is not limited thereto. The size and shape of the first to third emission areas EA1, EA2 and EA3 may be adjusted as desired according to required characteristics.

Each of the emission areas EA may be defined by a first opening OP1 and a second opening OP2. The second openings OP2 may completely surround the first openings OP1 when viewed from the top, respectively. The second openings OP2 may be completely surrounded by the non-emission area NLA when viewed from the top.

According to some embodiments, at least one first emission area EA1, at least one second emission areas EA2 and at least one third emission area EA3 arranged adjacent to each other may form a single pixel group PXG. A pixel group PXG may be the minimum unit which emits white light. However, the type and/or number of each of the first to third emission areas EA1, EA2 and EA3 forming a pixel group PXG may vary depending on embodiments.

FIG. 4 is a cross-sectional view taken along line X1 - X1' of FIG. 3. FIG. 4 shows a schematic cross section of the display layer DPL in the display area DA. Specifically, FIG. 4 shows the cross section of the substrate 110, the thin-film transistor layer 130, the display element layer 150 and the thin-film encapsulation layer 170 of the display device 10. The substrate 110 has been described above and thus will not be described again.

Referring to FIG. 4, the thin-film transistor layer 130 may be disposed on the substrate 110. The thin-film transistor layer 130 may include a first buffer layer 111, a thin-film transistor TFT, a gate insulator 113 as a gate insulating layer, a first insulating layer 121, a capacitor electrode CPE, a second insulating layer 123, a first connection electrode CNE1, a first via layer 125, a second connection electrode CNE2, and a second via layer 127.

The first buffer layer 111 may be disposed on the substrate 110. The first buffer layer 111 may include an inorganic film capable of preventing permeation of air or moisture. For example, the first buffer layer 111 may include a plurality of inorganic films stacked on one another alternately.

The thin-film transistor TFT may be disposed on the first buffer layer 111 and may form a pixel circuit connected to each of a plurality of pixels PX. For example, the thin-film transistor TFT may be a driving transistor or a switching transistor of the pixel circuit. The thin-film transistor TFT may include an active layer ACT, a source electrode SE, a drain electrode DE and a gate electrode GE.

The active layer ACT may be disposed on the first buffer layer 111. The active layer ACT may overlap with the gate electrode GE in the third direction (z-axis direction) and may be insulated (e.g., electrically insulated) from the gate electrode GE by the gate insulator 113. The material of a part of the active layer ACT may be made conductive to form the source electrode SE and the drain electrode DE.

The gate electrode GE may be disposed on the gate insulator 113. The gate electrode GE may overlap the active layer ACT with the gate insulator 113 interposed therebetween.

The gate insulator 113 may be disposed over the active layer ACT. The gate insulator 113 may cover the active layer ACT and the first buffer layer 111, and may insulate the active layer ACT from the gate electrode GE. The gate insulator 113 may include (or define) a contact hole therein through which the first connection electrode CNE1 passes.

The first insulating layer 121 may cover the gate electrode GE and the gate insulator 113. The first insulating layer 121 may include a contact hole through which the first connection electrode CNE1 passes. The contact hole of the first insulating layer 121 may be connected to the contact hole of the gate insulator 113 and the contact hole of the second insulating layer 123. One or more of the insulator and insulating layers may herein be referred to as 'an insulating layer.' Here a contact hole of such insulating layer may include the connected contact holes described above.

The capacitor electrode CPE may be disposed on the first insulating layer 121. The capacitor electrode CPE may overlap with the gate electrode GE in the third direction (z-axis direction). The capacitor electrode CPE and the gate electrode GE may form a capacitance.

The second insulating layer 123 may cover the capacitor electrode CPE and the first insulating layer 121. The second insulating layer 123 may include the contact hole through which the first connection electrode CNE1 passes. The contact hole of the second insulating layer 123 may be connected to the contact hole of the first insulating layer 121 and the contact hole of the gate insulator 113.

The first connection electrode CNE1 may be disposed on the second insulating layer 123. The first connection electrode CNE1 may electrically connect the drain electrode DE of the thin-film transistor TFT with the second connection electrode CNE2. The first connection electrode CNE1 may be extended through (e.g., inserted into) the contact hole formed (or provided) in the first insulating layer 121, the second insulating layer 123 and the gate insulator 113 to be in contact with the drain electrode DE of the thin-film transistor TFT. As being in contact, elements may form an interface therebetween, such as a physical interface.

The first via layer 125 may cover the first connection electrode CNE1 and the second insulating layer 123. The first via layer 125 may provide a flat surface over a non-flat profile of the underlying structures. The first via layer 125 may include a contact hole through which the second connection electrode CNE2 passes.

The first via layer 125 may include an organic insulating material. For example, the first via layer 125 may be formed of an acrylic resin, polyimide, polyamide, benzocyclobutene, a phenol resin, etc.

The second connection electrode CNE2 may be disposed on the first via layer 125. The second connection electrode CNE2 may be inserted into a contact hole formed in the first via layer 125 to be in contact with the first connection electrode CNE1. The second connection electrode CNE2 may electrically connect the first connection electrode CNE1 with an anode electrode AE.

The second via layer 127 may cover the second connection electrode CNE2 and the first via layer 125. The second via layer 127 may include a contact hole through which the anode electrode AE passes.

The second via layer 127 may include an organic insulating material. For example, the second buffer layer 127 may include the same material as the first via layer 125.

The display element layer 150 may be disposed on the thin-film transistor layer 130. The display element layer 150 may include emission structures ES, a pixel-defining layer 151, residual patterns 153, and a bank structure 160 of a bank layer.

According to the embodiment, the emission structure ES as a light emission structure may include a minimal structure which generates and/or emits light. The emission structures ES as light emission structures may include a first emission structure ES1 disposed in a first emission area EA1, a second emission structure ES2 disposed in a second emission area EA2, and a third emission structure ES3 disposed in a third emission area EA3. Each of the first emission structure ES1, the second emission structure ES2 and the third emission structure ES3 may be spaced apart from each other in a direction along the TFT layer 130.

An emission structure may include a light-emitting element, an element inorganic layer (or element inorganic pattern), an organic pattern and an electrode pattern together with each other. The first emission structure ES1 may include a first light-emitting element ED1, a first element inorganic layer IO1, a first organic pattern ELP1 and a first electrode pattern CEP1, the second emission structure ES2 may include a second light-emitting element ED2, a second element inorganic layer IO2, a second organic pattern ELP2 and a second electrode pattern CEP2, and the third emission structure ES3 may include a third light-emitting element ED3, a third element inorganic layer IO3, a third organic pattern ELP3 and a third electrode pattern CEP3.

The first emission structure ES1, the second emission structure ES2 and the third emission structure ES3 may have the same height in the direction parallel to the substrate 110. More detailed descriptions will be given below.

According to the embodiment, the light-emitting elements ED may include the first light-emitting element ED1 disposed in the first emission area EA1, the second light-emitting element ED2 disposed in the second emission area EA2, and the third light-emitting element ED3 disposed in the third emission area EA3. A light-emitting element may include an anode electrode an emissive layer (e.g., a light emission layer or pattern) and a cathode electrode together with each other. The first light-emitting element ED1 may include a first anode electrode AE1, a first emissive layer EL1 and a first cathode electrode CE1, the second light-emitting element ED2 may include a second anode electrode AE2, a second emissive layer EL2 and a second cathode electrode CE2, and the third light-emitting element ED3 may include a third anode electrode AE3, a third emissive layer EL3 and a third cathode electrode CE3.

The first to third light-emitting elements ED1, ED2 and ED3 may emit light of different colors depending on the materials of the first to third emissive layers EL1, EL2 and EL3. For example, the first light-emitting element ED1 may emit red light, the second light-emitting element ED2 may emit green light, and the third light-emitting element ED3 may emit blue light.

According to the embodiment, the anode electrodes AE may be disposed on the second via layer 127. The anode electrode AE may be electrically connected to the drain electrode DE of the thin-film transistor TFT through the first connection electrode CNE1 and the second connection electrode CNE2.

The anode electrodes AE may include a first anode electrode AE1, a second anode electrode AE2, and a third anode electrode AE3. The first anode electrode AE1, the second anode electrode AE2 and the third anode electrode AE3 may be spaced apart from one another in a direction along the display element layer 150.

The first to third anode electrodes AE1, AE2 and AE3 may all have the same height. Herein, the terms height and thickness may be used interchangeably. It should be noted that the first to third anode electrodes AE1, AE2 and AE3 may have height deviations of about 5% depending on process errors. The height (or thickness) may refer to a total height (or total thickness) of a material pattern of an element, a distance from a reference such as from an underlying layer to a point or location of the material pattern which is furthest from the reference, etc.

The anode electrodes AE may have a stack structure of a material layer having a high work function such as indium-tin-oxide (ITO), indium-zinc-oxide (IZO), zinc oxide (ZnO) and indium oxide (In₂O₃), and a reflective material layer such as silver (Ag), magnesium (Mg), aluminium (Al), platinum (Pt), lead (Pb), palladium (Pd), gold (Au), nickel (Ni), neodymium (Nd), iridium (Ir), chromium (Cr), lithium (Li), or a combination thereof. For example, the anode electrodes AE may have, but is not limited to, a multilayer structure of ITO/Mg, ITO/MgF, ITO/Ag, and ITO/Ag/ITO.

According to the embodiment, the pixel-defining layer 151 may be located over the second via layer 127 and the anode electrodes AE. A material of the pixel-defining layer 151 may define first openings OP1. The pixel-defining layer 151 may be disposed entirely on the second via layer 127 and may expose parts of the upper surfaces of the anode electrodes AE to outside the pixel-defining layer 151.

The pixel-defining layer 151 may include an inorganic insulating material. For example, the pixel-defining layer 151 may include aluminium oxide, titanium oxide, tantalum oxide, hafnium oxide, zinc oxide, silicon oxide, silicon nitride, and silicon oxynitride.

According to the embodiment, the bank structure 160 as a material pattern of the bank layer may be located on a material pattern of the pixel-defining layer 151. A material of the bank structure 160 may define second openings OP2 of the bank layer. The bank structure 160 may include a first bank layer 161 and a second bank layer 163 which include different metal materials. The second bank layer 163 may include tips TIP which protrude toward the first openings OP1 and further from a sidewall of the first bank layer 161. More detailed descriptions will be given below.

According to the embodiment of the present disclosure, the emissive layers EL may be disposed on the anode electrodes AE. The emissive layers EL may be organic emissive layers made of (or including) an organic material and may be formed on the anode electrodes AE via a deposition process. When the thin-film transistor TFT applies a predetermined voltage to the anode electrode AE and the cathode electrode CE receives a common voltage or cathode voltage, the holes and electrons may move to the emissive layer EL through a hole transporting layer and an electron transporting layer thereof (not shown), respectively, and they combine in the emissive layer EL to emit light.

The emissive layers EL may include an emissive pattern provided in plural including a first emissive layer EL1, a second emissive layer EL2, and a third emissive layer EL3. For example, the first emissive layer EL1 may emit red light, the second emissive layer EL2 may emit green light, and the third emissive layer EL3 may emit blue light, but the present disclosure is not limited thereto.

The first emissive layer EL1, the second emissive layer EL2 and the third emissive layer EL3 may have different heights at respective light emission areas. Herein, the terms height and thickness may be used interchangeably. For example, the first emissive layer EL1 which emits red light may have the highest height, and the third emissive layer EL3 which emits blue light may have the lowest height. More detailed descriptions will be given below.

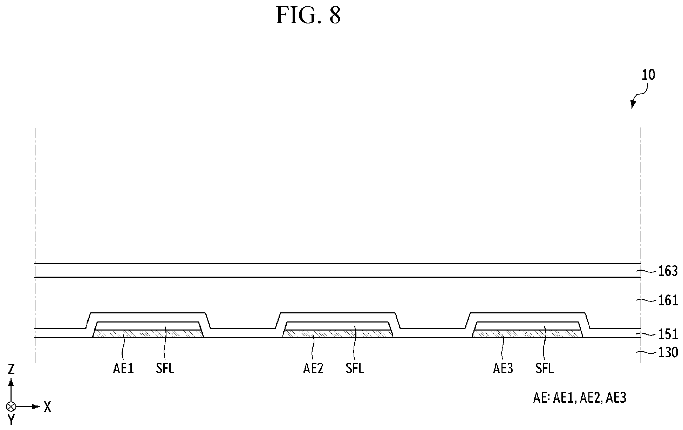

According to the embodiment, the residual patterns 153 may be located between the anode electrodes AE and the pixel-defining layer 151 in the third direction (z-axis direction). The residual patterns 153 may be residues of a sacrificial layer SFL (see FIG. 8) which is temporarily formed on the anode electrodes AE and from which portions of the sacrificial layer SFL are removed during the process of fabricating the display device 10. In the cross-sectional view, the residual patterns 153 may be surrounded by corresponding material portions of the pixel-defining layer 151, the anode electrodes AE and the emissive layers EL.

According to the embodiment, the cathode electrode CE may be disposed on the emissive layer EL. The cathode electrode CE may include a transparent conductive material so that light generated in the emissive layer EL can pass through the cathode electrode and exit the light emission area. The cathode electrode CE may receive a common voltage or a low-level voltage. In other words, when the anode electrode AE receives the voltage equal to the data voltage and the cathode electrode CE receives the low-level voltage, a potential difference is formed between the anode electrode AE and the cathode electrode CE, so that the emissive layer EL can emit light.

The cathode electrode CE may include a material layer having a small work function such as Li, Ca, LiF/Ca, LiF/Al, Al, Mg, Ag, Pt, Pd, Ni, Au, Nd, Ir, Cr, BaF and Ba, or a combination thereof (e.g., a combination of Ag and Mg). The cathode electrode CE may further include a transparent metal oxide layer disposed on the material layer having a small work function.

The cathode electrodes CE may include a first cathode electrode CE1, a second cathode electrode CE2, and a third cathode electrode CE3. The first cathode electrode CE1 may be disposed in the first emission area EA1, the second cathode electrode CE2 may be disposed in the second emission area EA2, and the third cathode electrode CE3 may be disposed in the third emission area EA3.

The first cathode electrode CE1, the second cathode electrode CE2 and the third cathode electrode CE3 may be spaced apart from each other. The first cathode electrode CE1, the second cathode electrode CE2 and the third cathode electrode CE3 may be electrically connected with one another not directly but through the first bank layer 161 of the bank structure 160.

The first to third cathode electrodes CE1, CE2 and CE3 may all have the same height. Herein, the terms height and thickness may be used interchangeably. It should be noted that the first to third cathode electrodes CE1, CE2 and CE3 may have height deviations of about 5% depending on process errors.

According to the embodiment, organic patterns ELP may be disposed on the second bank layer 163. The organic patterns ELP may surround the periphery of the first openings OP1 defined in the pixel-defining layer 151. The organic patterns ELP may include discrete patterns such as a first organic pattern ELP1 surrounding a first light-emitting element ED1, a second organic pattern ELP2 surrounding a second light-emitting element ED2, and a third organic pattern ELP3 surrounding a third light-emitting element ED3.

The organic patterns ELP may include the same material as the emissive layers EL. For example, the first organic pattern ELP1 may include the same material as the first emissive layer EL1, the second organic pattern ELP2 may include the same material as the second emissive layer EL2, and the third organic pattern ELP3 may include the same material as the third emissive layer EL3.

The organic patterns ELP may be traces which are formed as a part of the material for the emissive layer EL is disconnected from a remaining part of the material forming the emissive layer EL during the process of fabricating the display device 10 since the bank structure 160 includes the tips TIP. A respective organic pattern and a respective emissive layer may be respective portions of a same material layer, such as to be considered in a same layer as each other. As being in a same layer, elements may be formed in a same process and/or include a same material as each other, elements may be respective portions of a same material layer, elements may be on a same layer by forming an interface with a same underlying or overlying layer, elements may be coplanar with each other or be disposed in a same thickness, etc., without being limited thereto.

According to the embodiment, the electrode patterns CEP may be disposed on the organic layers ELP. The electrode patterns CEP may surround the periphery of the first openings OP1. The electrode patterns CEP may include the same material as the cathode electrodes CE. The electrode patterns CEP may include a first electrode pattern CEP1 surrounding a first light-emitting element ED1, a second electrode pattern CEP2 surrounding a second light-emitting element ED2, and a third electrode pattern CEP3 surrounding a third light-emitting element ED3.

The electrode patterns CEP may be traces which are formed as a part of the material for the cathode electrodes CE is disconnected from the cathode electrodes CE during the process of fabricating the display device 10 since the bank structure 160 includes the tips TIP. The electrode patterns CEP and the cathode electrodes CE may be respective portions of a same material layer, such as to be considered in a same layer as each other.

According to the embodiment, the element inorganic layers IO may be disposed on the light-emitting elements ED. The element inorganic layers IO can prevent oxygen or moisture from permeating into the light-emitting elements ED by entirely covering the light-emitting elements ED.

The element inorganic layers IO may include a first element inorganic layer IO1, a second element inorganic layer IO2, and a third element inorganic layer IO3. The first element inorganic layer IO1 may be disposed on the first light-emitting element ED1 in the first emission area EA1, the second element inorganic layer IO2 may be disposed on the second light-emitting element ED2 in the second emission area EA2, and the third element inorganic layer IO3 may be disposed on the third light-emitting element ED3 in the third emission area EA3. The first element inorganic layer IO1, the second element inorganic layer IO2 and the third element inorganic layer IO3 may be spaced apart each other in the first direction (x-axis direction) in the non-emission area NLA.

The element inorganic layers IO may include an inorganic insulating material. For example, the element inorganic layers IO may include one of silicon nitride, silicon oxide, and silicon oxynitride.

The first element inorganic layer IO1, the second element inorganic layer IO2 and the third element inorganic layer IO3 may have different heights. Herein, the terms height and thickness may be used interchangeably. For example, the first element inorganic layer IO1 overlapping with the first emissive layer EL1 having the highest height may have the lowest height, and the third element inorganic layer IO3 overlapping with the third emissive layer EL3 having the lowest height may have the highest height. More detailed descriptions will be given below.

According to some embodiments, the first element inorganic layer IO1 may include a first surface up1 in contact with the organic encapsulation layer 171, the second element inorganic layer IO2 may include a second surface up2 in contact with the organic encapsulation layer 171, and the third element inorganic layer IO3 may include a third surface up3 in contact with the organic encapsulation layer 171.

The first surface up1 of the first element inorganic layer IO1, the second surface up2 of the second element inorganic layer IO2 and the third surface up3 of the third element inorganic layer IO3 may be located on the same line in the direction parallel to the substrate 110. That is, the upper surfaces of the element inorganic layers IO may be coplanar with each other in a direction along the substrate 110. More detailed descriptions will be given below.

According to the embodiment, the thin-film encapsulation layer 170 may be disposed on the display element layer 150. The thin-film encapsulation layer 170 may include an organic encapsulation layer 171, a first inorganic encapsulation layer 173, and a second inorganic encapsulation layer 175.

According to the embodiment, the organic encapsulation layer 171 may be disposed on the element inorganic layer IO. The organic encapsulation layer 171 may provide a flat surface over the element inorganic layers IO.

The organic encapsulation layer 171 may include a polymer-based material. For example, the organic encapsulation layer 171 may include an acrylic resin, an epoxy resin, polyimide, polyethylene, etc.

In the process of fabricating the display device 10, the spreadability of the organic encapsulation layer 171 may be affected by the level differences of the underlying structure. For example, the organic encapsulation layer 171 can spread less evenly as the underlying structure has non-uniform levels, while the organic encapsulation layer 171 can spread more evenly as the underlying structure has uniform levels. If the organic encapsulation layer 171 spreads unevenly, the organic encapsulation layer 171 may not be applied completely.

In the display device 10 according to the embodiment, the first emission structure ES1, the second emission structure ES2 and the third emission structure ES3 have the same height, so that a uniform level difference may be repeated between the emission structures ES and the bank structure 160. Accordingly, in the display device 10 according to the embodiment, the organic encapsulation layer 171 can spread more evenly. More detailed descriptions will be given below.

According to the embodiment, the first inorganic encapsulation layer 173 may be located on the organic encapsulation layer 171. The first inorganic encapsulation layer 173 can protect the underlying structure from permeation of moisture and oxygen.

The first inorganic encapsulation layer 173 may include an inorganic insulating material. For example, the first inorganic encapsulation layer 173 may include one of silicon nitride, silicon oxide, and silicon oxynitride.

According to the embodiment, the second inorganic encapsulation layer 175 may be located on the first inorganic encapsulation layer 173. In the process of fabricating the display device 10, the first inorganic encapsulation layer 173 and the second inorganic encapsulation layer 175 may be formed continuously in the same chamber.

The second inorganic encapsulation layer 175 may have a lower film density (e.g., porosity) than the first inorganic encapsulation layer 173. The second inorganic encapsulation layer 175 may have porosity in chemical bonds which is higher than those of the first inorganic encapsulation layer 173 and thus may physically absorb reaction gases generated during reliability evaluation. That is, the second inorganic encapsulation layer 175 may have gas porosity which is higher than a gas porosity of the first inorganic encapsulation layer 173 and thus may physically absorb the reaction gases.

The second inorganic encapsulation layer 175 may include an inorganic insulating material. For example, the second inorganic encapsulation layer 175 may be silicon nitride.

In some embodiments, the second inorganic encapsulation layer 175 may have a height of about 10% to about 17% of the height of the first inorganic encapsulation layer 173.

In some embodiments, the second inorganic encapsulation layer 175 may have an oxygen content of about 10% or less.

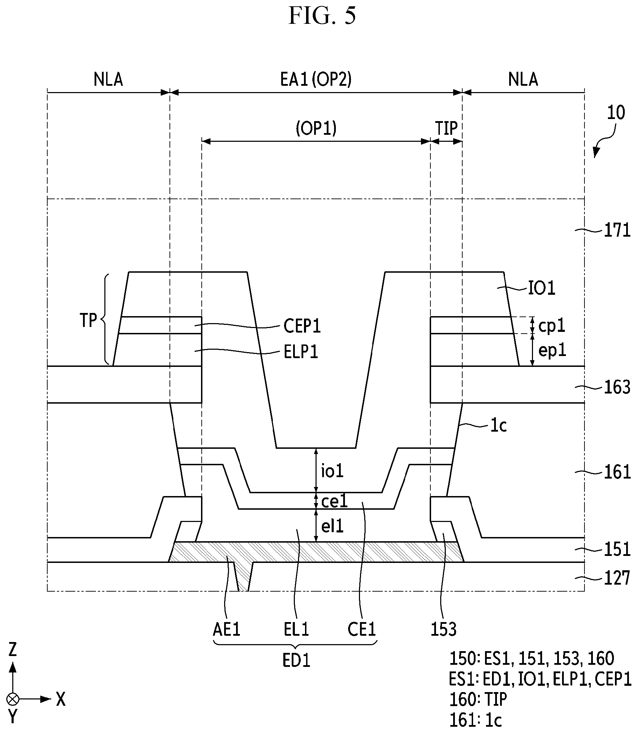

FIG. 5 is a cross-sectional view of a display element layer 150 in the first emission area in FIG. 4.

Referring to FIG. 5, in the first emission area EA1, the first emission structure ES1 may include a first light-emitting element ED1, a first element inorganic layer IO1, a first organic pattern ELP1, and a first electrode pattern CEP1.

According to the embodiment, the residual patterns 153 may be located in contact with the both of opposing sides of the first emissive layer EL1 in the first direction (x-axis direction). In addition, the residual patterns 153 may overlap with the tips TIP of the bank structure 160 in the third direction (z-axis direction).

The residual patterns 153 may include an oxide semiconductor. For example, the residual patterns 153 may include at least one of indium-gallium-zinc oxide (IGZO), zinc-tin oxide (ZTO), indium-tin oxide (IZO), etc.

According to the embodiment, the pixel-defining layer 151 may be in contact with the residual patterns 153 and the first anode electrode AE1. A material of the pixel-defining layer 151 may surround the first openings OP1.

According to the embodiment, the first bank layer 161 may be located on the pixel-defining layer 151. The first bank layer 161 may include a metal with high electrical conductivity, for example, may include aluminium (Al).

In some embodiments, the first bank layer 161 may include a side surface 1c facing (or defining) a portion of the first opening OP1. The side surface 1c of the first bank layer 161 may be an inclined surface.

According to the embodiment of the present disclosure, the second bank layer 163 may be disposed in contact with the first bank layer 161. The second bank layer 163 may include a material having a lower etch rate than the first bank layer 161. For example, the second bank layer 163 may include titanium (Ti).

The second bank layer 163 may have tips TIP as extended portions which protrude toward the first openings OP1 and further than the side surface 1c of the first bank layer 161. Therefore, undercuts may be formed between the side surfaces 1c of the first bank layer 161 and the tips TIP of the second bank layer 163.

According to the embodiment, the first emissive layer EL1 and the first cathode electrode CE1 may be in contact with the side surface 1c of the first bank layer 161.

In the display device 10 according to the embodiment, the first emissive layer EL1 and the first cathode electrode CE1 can be formed without a separate fine metal mask in the fabrication process. That is to say, the process of forming the first emissive layer EL1 and the process of forming the first cathode electrode CE1 may be performed across the entire surface of the first anode electrode AE1. Accordingly, the first emissive layer EL1 and the first cathode electrode CE1 may be located not only on the first anode electrode AE1 but also in contact with the side surface 1c of the first bank layer 161.

According to the embodiment, the first cathode electrode CE1 may entirely cover the first emissive layer EL1 in the second opening OP2. This may mean that the process of forming the first cathode electrode CE1 has higher step coverage characteristics than the process of forming the first emissive layer EL1. Such a fabrication process will be described later.

According to the embodiment, the first organic pattern ELP1 may be disposed on the second bank layer 163. The first organic pattern ELP1 may overlap with the tip TIP of the second bank layer 163 in the third direction (z-axis direction). The first organic pattern ELP1 may cover a part of the second bank layer 163 in the non-emission area NLA.

In the process of fabricating the display device 10, the first organic pattern ELP1 may be formed by covering the entire surface of the second bank layer 163 with an organic material layer and then partially etching the organic material layer via a subsequent etching process. Therefore, the first organic pattern ELP1 may define a portion of a trench portion TP in the non-emission area NLA. The trench portion TP of the first organic pattern ELP1 may be exposed and not covered by the first element inorganic layer IO1.

In some embodiments, the height el1 of the first emissive layer EL1 in the first opening OP1 may be equal to the height ep1 of the first organic pattern ELP1 adjacent to the first opening OP1. Herein, equal dimensions, for example, may be planned as ideally equal but normal fabrication tolerances may cause the resulting dimensions to vary by about 5% for different pieces.

According to the embodiment, the first electrode pattern CEP1 may be disposed on the first organic pattern ELP1. The first electrode pattern CEP1 may overlap with the tip TIP of the second bank layer 163 in the third direction (z-axis direction). The first electrode pattern CEP1 may cover a part of the first organic pattern ELP1 in the non-emission area NLA.

In the process of fabricating the display device 10, the first electrode pattern CEP1 may be formed by covering the entire surface of the second bank layer 163 with an electrode material layer and then partially etching the electrode material layer via a subsequent etching process. Therefore, the first electrode pattern CEP1 may define a portion of a trench portion TP in the non-emission area NLA. The trench portion TP of the first electrode pattern CEP1 may be exposed and not covered by the first element inorganic layer IO1.

In some embodiments, the height ce1 of the first cathode electrode CE1 in the first opening OP1 may be equal to the height cp1 of the first electrode pattern CEP1 adjacent to the first opening OP1. Herein, equal dimensions, for example, may be planned as ideally equal but normal fabrication tolerances may cause the resulting dimensions to vary by about 5% for different pieces.

According to the embodiment, the first element inorganic layer IO1 may cover the first light-emitting element ED1 and the first electrode pattern CEP1. The first element inorganic layer IO1 may be in contact with the first cathode electrode CE1 and the side surface 1c of the first bank layer 161 in the second opening OP2, and may cover the protruding tip TIP of the second bank layer 163. In addition, the first element inorganic layer IO1 may cover the first organic pattern ELP1 and the first electrode pattern CEP1 in the non-emission area NLA.

In the process of fabricating the display device 10, the first element inorganic layer IO1 may be formed by covering the entire surface of the second bank layer 163 with an inorganic material layer and then partially etching the inorganic material layer via a subsequent etching process. Therefore, the first element inorganic layer IO1 may define a portion of a trench portion TP in the non-emission area NLA. The trench portion TP of the first element inorganic layer IO1 may be located on the same line as the trench portion TP of the first organic pattern ELP1 and the first electrode pattern CEP1. That is, sidewalls of the element inorganic layer, the organic pattern and the electrode pattern which define thickness portions (or volume portions) of a trench may be coplanar with each other.

A cross-sectional profile of the first element inorganic layer IO1 may include a level difference in the first emission area EA1 relative to the non-emission area NLA. The level difference created by the first element inorganic layer IO1 may be flattened by the organic encapsulation layer 171.

The height io1 of the first element inorganic layer IO1 may be uniform in the first emission area EA1 and the non-emission area NLA. For example, the height io1 of the first element inorganic layer IO1 may range from about 1.05 micrometers to about 1.15 micrometers.

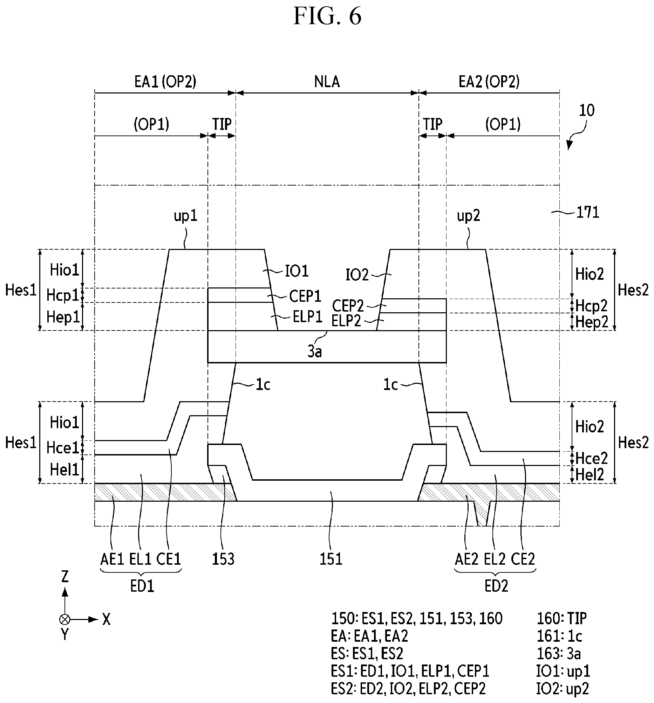

FIG. 6 is a schematic cross-sectional view of the display element layer 150 in the non-emission area NLA located between the first emission area and the second emission area as adjacent emission areas in FIG. 4.

Referring to FIG. 6, according to the embodiment, the first emission structure ES1 and the second emission structure ES2 may be spaced apart from each other with a material portion of the pixel-defining layer 151 and the bank structure 160 therebetween. In other words, the first emission structure ES1 and the second emission structure ES2 may be spaced apart from each other with a thickness portion of the organic encapsulation layer 171 therebetween in the non-emission area NLA.

According to the embodiment of the present disclosure, the first emissive layer EL1 and the first cathode electrode CE1 included in the first emission structure ES1 may be in contact with one side surface 1c of the first bank layer 161 which defines the first emission area EA1, and the second emissive layer EL2 and the second cathode electrode CE2 included in the second emission structure ES2 may be in contact with the opposite side surface 1c of the first bank layer 161 which defines the second emission area EA2. The first cathode electrode CE1 included in the first emission structure ES1 and the second cathode electrode CE2 included in the second emission structure ES2 may be electrically connected with each other by the first bank layer 161.

According to the embodiment of the present disclosure, the height Hes1 of the first emission structure ES1 may be defined as the sum of the height Hel1 of the first emissive layer EL1, the height Hce1 of the first cathode electrode CE1 and the height Hio1 of the first element inorganic layer IO1 in the first opening OP1. In addition, the height Hes1 of the first emission structure ES1 may be defined as the sum of the height Hep1 of the first organic pattern ELP1, the height Hcp1 of the first electrode pattern CEP1 and the height Hio1 of the first element inorganic layer IO1 in the non-emission area NLA which is adjacent to the first emission area EA1. Each of the heights Hes1 may represent a thickness portion of the first emission structure ES1.

As described above, the height Hel1 of the first emissive layer EL1 included in the first emission structure ES1 and the height Hep1 of the first organic pattern ELP1 may be equal to each other within the process deviations, and the height Hce1 of the first cathode electrode CE1 and the height Hcp1 of the first electrode pattern CEP1 may also be equal to each other within the process deviations. Accordingly, the height Hes1 of the first emission structure ES1 in the first opening OP1 may be equal to the height Hes1 of the first emission structure ES1 in the non-emission area NLA adjacent to the first emission area EA1.

According to the embodiment of the present disclosure, the height Hes2 of the second emission structure ES2 may be defined as the sum of the height Hel2 of the second emissive layer EL2, the height Hce2 of the second cathode electrode CE2 and the height Hio2 of the second element inorganic layer IO2 in the first opening OP1. In addition, the height Hes2 of the second emission structure ES2 may be defined as the sum of the height Hep2 of the second organic pattern ELP2, the height Hcp2 of the second electrode pattern CEP2 and the height Hio2 of the second element inorganic layer IO2 in the non-emission area NLA which is adjacent to the second emission area EA2. Each of the heights Hes2 may represent a thickness portion of the second emission structure ES2.

According to the embodiment, the height Hel2 of the second emissive layer EL2 and the height Hep2 of the second organic pattern ELP2 may be equal to each other within the process deviations, and the height Hce2 of the second cathode electrode CE2 and the height Hcp2 of the second electrode pattern CEP2 may also be equal to each other within the process deviations. Accordingly, the height Hes2 of the second emission structure ES2 in the first opening OP1 may be equal to the height Hes2 of the second emission structure ES2 in the non-emission area NLA adjacent to the second emission area EA2.

According to the embodiment of the present disclosure, the height Hel1 of the first emissive layer EL1 included in the first emission structure ES1 and the height Hel2 of the second emissive layer EL2 included in the second emission structure ES2 may have different values. For example, the height Hel1 of the first emissive layer EL1 may be higher than the height Hel2 of the second emissive layer EL2. Specifically, the height Hel1 of the first emissive layer EL1 may be at least 1.5 times higher than the height Hel2 of the second emissive layer EL2, but the present disclosure is not limited thereto.

In the display device 10 according to the embodiment of the present disclosure, in order to compensate for the difference between the height Hel1 of the first emissive layer EL1 and the height Hel2 of the second emissive layer EL2, the first element inorganic layer IO1 and the second element inorganic layer IO2 have different heights. Accordingly, at the non-emission area NLA in the display device 10 according to the embodiment of the present disclosure, the height Hes1 of the first emission structure ES1 may be equal to the height Hes2 of the second emission structure ES2 such that upper surfaces are coplanar with each other.

For example, in the display device 10, when the height Hel1 of the first emissive layer EL1 is higher than the height Hel2 of the second emissive layer EL2 in the first opening OP1, by forming the height Hio1 of the first element inorganic layer IO1 lower than the height Hio2 of the second element inorganic layer IO2 in a subsequent process, so that the height Hes1 of the first emission structure ES1 and the height Hes2 of the second emission structure ES2 may become equal.

According to the embodiment, the height Hce1 of the first cathode electrode CE1 may be equal to the height Hce2 of the second cathode electrode CE2 within process errors. The redundant descriptions will be omitted.

In some embodiments, the height Hio1 of the first element inorganic layer IO1 and the height Hio2 of the second element inorganic layer IO2 may be adjusted within a range of about 1.05 micrometers to about 1.15 micrometers.

In some embodiments, the film density of the first element inorganic layer IO1 may be higher than that of the second element inorganic layer IO2. Accordingly, even though the first element inorganic layer IO1 is thinner than the second element inorganic layer IO2, the first element inorganic layer IO1 can prevent permeation of moisture similarly to that of the second element inorganic layer IO2.

In some embodiments, the first surface up1 of the first element inorganic layer IO1 and the second surface up2 of the second element inorganic layer IO2 may be located on the same line to be coplanar with each other in the first direction (x-axis direction), with deviations of about 5% or less depending on process errors. The first surface up1 of the first element inorganic layer IO1 may be the top surface of the first element inorganic layer IO1 which is furthest from the substrate 110, and the second surface up2 of the second element inorganic layer IO2 may be the top surface of the second element inorganic layer IO2 which is furthest from the substrate 110.

In the non-emission area NLA, the first surface up1 of the first element inorganic layer IO1 and the second surface up2 of the second element inorganic layer IO2 may be spaced apart from each other in the first direction (x-axis direction) with a thickness portion of the organic encapsulation layer 171 therebetween.

According to the embodiment of the present disclosure, the second bank layer 163 may include tips TIP which protrude from both of opposing sides of an emission area EA toward the emission area EA, and further from the side surface 1c of the first bank layer 161.

In some embodiments, the second bank layer 163 may include an upper surface 3a facing the organic encapsulation layer 171. A part of the upper surface 3a of the second bank layer 163 may be in contact with the first organic pattern ELP1 and the second organic pattern ELP2, and another part of the upper surface 3a may be in contact with the organic encapsulation layer 171.

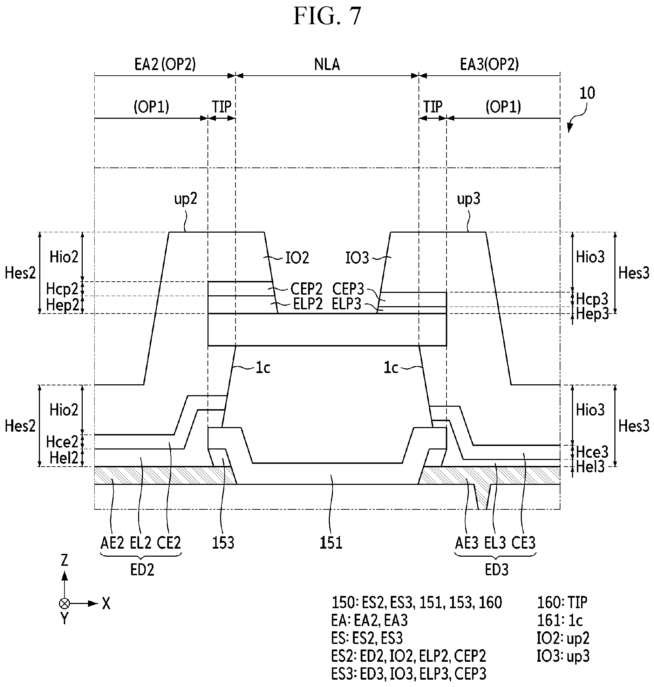

FIG. 7 is a schematic cross-sectional view of the display element layer 150 in the non-emission area located between the second emission area and the third emission area as adjacent emission areas in FIG. 4.

Referring to FIG. 7, according to the embodiment, the second emission structure ES2 and the third emission structure ES3 may be spaced apart from each other with the pixel-defining layer 151 and the bank structure 160 therebetween. In addition, the second emission structure ES2 and the third emission structure ES3 may be spaced apart from each other with a thickness portion of the organic encapsulation layer 171 therebetween in the non-emission area NLA.

According to the embodiment of the present disclosure, the second emissive layer EL2 and the second cathode electrode CE2 included in the second emission structure ES2 may be in contact with one side surface 1c of the first bank layer 161, and the third emissive layer EL3 and the third cathode electrode CE3 included in the third emission structure ES3 may be in contact with the opposite side surface 1c of the first bank layer 161. The second cathode electrode CE2 included in the second emission structure ES2 and the third cathode electrode CE3 included in the third emission structure ES3 may be electrically connected with each other by the first bank layer 161.

The definition of the height Hes2 of the second emission structure ES2 has been described above, and, therefore, the redundant descriptions will be omitted.

In some embodiments, the height Hes3 of the third emission structure ES3 may be defined as the sum of the height Hel3 of the third emissive layer EL3, the height Hce3 of the third cathode electrode CE3 and the height Hio3 of the third element inorganic layer IO3 in the first opening OP1. In addition, the height Hes3 of the third emission structure ES3 may be defined as the sum of the height Hep3 of the third organic pattern ELP3, the height Hcp3 of the third electrode pattern CEP3 and the height Hio3 of the third element inorganic layer IO3 in the non-emission area NLA.

The height Hel3 of the third emissive layer EL3 and the height Hep3 of the third organic pattern ELP3 may be equal to each other within the process deviations, and the height Hce3 of the third cathode electrode CE3 and the height Hep3 of the third electrode pattern CEP3 may also be equal to each other within the process deviations. Accordingly, the height Hes3 of the third emission structure ES3 in the first opening OP1 may be equal to the height Hes3 of the third emission structure ES3 in the non-emission area NLA.

According to the embodiment of the present disclosure, the height Hel2 of the second emissive layer EL2 and the height Hel3 of the third emissive layer EL3 may have different values. For example, the height Hel2 of the second emissive layer EL2 may be higher than the height Hel3 of the third emissive layer EL3. Specifically, the height Hel2 of the second emissive layer EL2 may be at least 2.5 times higher than the height Hel3 of the third emissive layer EL3, but the present disclosure is not limited thereto.

In the display device 10 according to the embodiment of the present disclosure, in order to compensate for the difference between the height Hel2 of the second emissive layer EL2 and the height Hel3 of the third emissive layer EL3, the second element inorganic layer IO2 and the third element inorganic layer IO3 have different heights. Accordingly, in the display device 10 according to the embodiment of the present disclosure, the height Hes2 of the second emission structure ES2 may be equal to the height Hes3 of the third emission structure ES3.

For example, at the non-emission area NLA in the display device 10, when the height Hel2 of the second emissive layer EL2 is higher than the height Hel3 of the third emissive layer EL3 in the first opening OP1, by forming the height Hio2 of the second element inorganic layer IO2 lower than the height Hio3 of the third element inorganic layer IO3 in a subsequent process, so that the height Hes2 of the second emission structure ES2 and the height Hes3 of the third emission structure ES3 may become equal.

According to the embodiment, the height Hce2 of the second cathode electrode CE2 may be equal to the height Hce3 of the third cathode electrode CE3 within process errors. The redundant descriptions will be omitted.

In some embodiments, the height Hio2 of the second element inorganic layer IO2 and the height Hio3 of the third element inorganic layer IO3 may be adjusted within a range of about 1.05 micrometers to about 1.15 micrometers.

In some embodiments, the film density of the second element inorganic layer IO2 may be higher than that of the third element inorganic layer IO3. Accordingly, even though the second element inorganic layer IO2 is thinner than the third element inorganic layer IO3, the second element inorganic layer IO2 can prevent permeation of moisture similarly to that of the third element inorganic layer IO3.

In some embodiments, the second surface up2 of the second element inorganic layer IO2 and the third surface up3 of the third element inorganic layer IO3 may be located on the same line in the first direction (x-axis direction), with deviations of about 5% or less depending on process errors. The second surface up2 of the second element inorganic layer IO2 may be the top surface of the second element inorganic layer IO2, and the third surface up3 of the third element inorganic layer IO3 may be the top surface of the third element inorganic layer IO3.

In the non-emission area NLA, the second surface up2 of the second element inorganic layer IO2 and the third surface up3 of the third element inorganic layer IO3 may be spaced apart from each other in the first direction (x-axis direction) with a thickness portion of the organic encapsulation layer 171 therebetween.

Referring back to FIGS. 4 to 7, the first emissive layer EL1, the second emissive layer EL2 and the third emissive layer EL3 according to the embodiment may have different heights. For example, the height Hel1 of the first emissive layer EL1 may be the highest among the emissive layers EL, and the height Hel3 of the third emissive layer EL3 may be the lowest among the emissive layers EL.

In the display device 10 according to the embodiment of the present disclosure, the organic encapsulation layer 171 can spread evenly along the display element layer 150 since uppermost surfaces of the first emission structure ES1, the second emission structure ES2 and the third emission structure ES3 have the same height (e.g., are substantially coplanar with each other) in a direction along the display element layer 150.

Accordingly, the display device 10 according to the embodiment may include the first element inorganic layer IO1, the second element inorganic layer IO2 and the third element inorganic layer IO3 having different heights in order to compensate for the different heights of the emissive layers EL. For example, the height Hio1 of the first element inorganic layer IO1 may be the lowest among the element inorganic layers IO, and the height Hio3 of the third element inorganic layer IO3 may be the highest among the element inorganic layers IO.

The first element inorganic layer IO1, the second element inorganic layer IO2 and the third element inorganic layer IO3 may have different film densities. For example, the film density of the first element inorganic layer IO1 having the lowest height may be the highest among the element inorganic layers IO, and the film density of the third element inorganic layer IO3 having the highest height may be the lowest among the element inorganic layers IO. Accordingly, the water vapor transmission rate (WVTR) values of the first element inorganic layer IO1, the second element inorganic layer IO2 and the third element inorganic layer IO3 included in the display device 10 according to the embodiment may be the same.

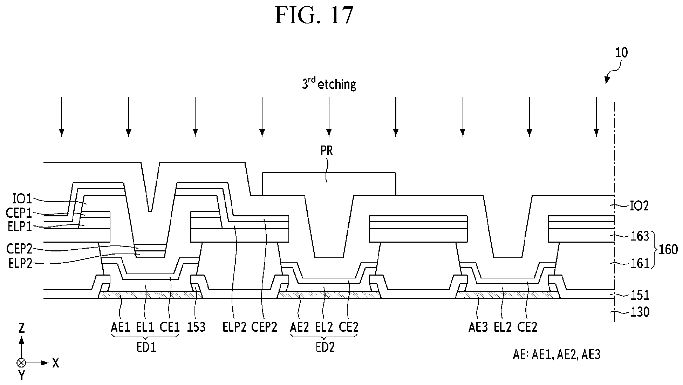

FIGS. 8 to 18 are cross-sectional views for illustrating a method of fabricating (or providing) the display element layer 150 in FIG. 4. Hereinafter, the process of fabricating the display element layer 150 will be described with respect to the order of forming different layers.

Referring to FIG. 8, a plurality of anode electrodes AE, a sacrificial layer SFL including sacrificial patterns, a pixel-defining layer 151 in a preliminary form, a first bank layer 161 in a preliminary form and a second bank layer 163 in a preliminary form are formed (or provided) on a thin-film transistor layer 130 as a pixel circuit layer. The structure of the thin-film transistor layer 130 has been described above with reference to FIG. 4, and, therefore, the redundant descriptions will be omitted.

The anode electrodes AE1, AE2 and AE3 may be anode patterns spaced apart from each other on the thin-film transistor layer 130, in a direction along the thin-film transistor layer 130. Material portions of the sacrificial layer SFL may be disposed as a sacrificial pattern on each of the anode electrodes AE1, AE2 and AE3. The sacrificial layer SFL may prohibit the anode electrodes AE from being in contact with the pixel-defining layer 151.

The pixel-defining layer 151 may be disposed on the sacrificial layer SFL. The preliminary form of the pixel-defining layer 151 may cover an entirety of the sacrificial layer SFL, the anode electrodes AE and the thin-film transistor layer 130.

The preliminary form of the first bank layer 161 and the preliminary form of the second bank layer 163 may be disposed on the preliminary form of the pixel-defining layer 151. The preliminary form of the first bank layer 161 and the preliminary form of the second bank layer 163 may be stacked on each other sequentially. The preliminary form of the first bank layer 161 and the preliminary form of the second bank layer 163 may entirely cover the preliminary form of the pixel-defining layer 151.

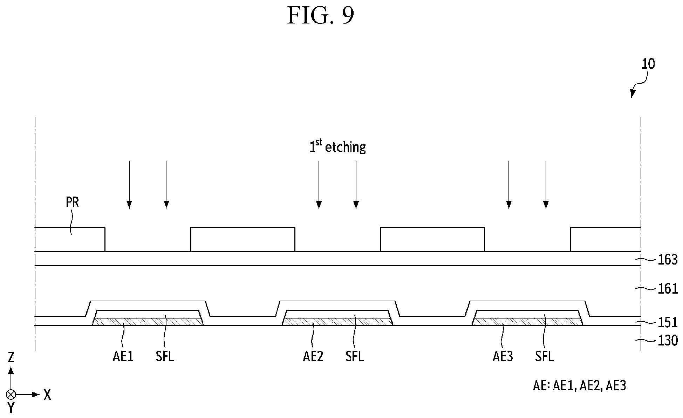

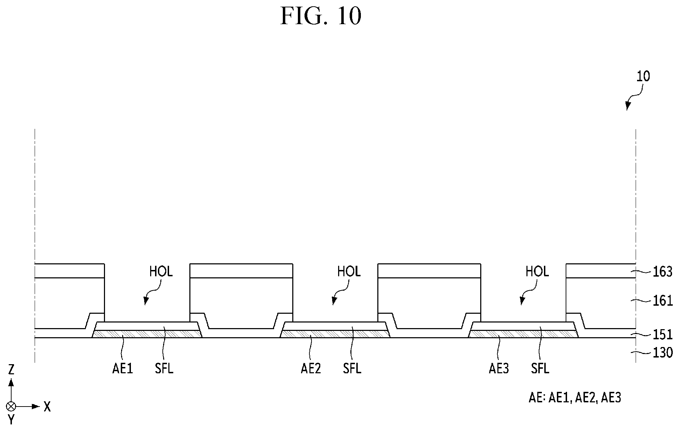

Subsequently, referring to FIGS. 9 and 10, a plurality of photoresists PR including first photoresist patterns of a first photoresist layer is formed on the preliminary form of the second bank layer 163. The photoresists PR may be spaced apart from each other to define exposing portions between the photoresist patterns which overlap with the anode electrodes AE. Subsequently, a first etching process (1^{st} etching) is performed using the plurality of photoresists PR as a mask. For example, the first etching process (1^{st} etching) may be performed as a dry etching process.

In this process, portions of the preliminary form of the first bank layer 161, the preliminary form of the second bank layer 163 and the preliminary form of the pixel-defining layer 151 which do not overlap with the photoresists PR may be isotropically etched. Accordingly, holes HOL may be formed at the exposing portions overlapping with the anode electrodes AE in this process. In this process, the sacrificial layer SFL located at the portions overlapping with the holes HOL may be exposed at the holes to outside the stacked structure including patterns of the first bank layer 161, the second bank layer 163 and the the pixel-defining layer 151. Here, sidewalls (or side surfaces) of these layers within the stacked structure respectively define a thickness portion (or a volume portion) at each of the holes HOL.

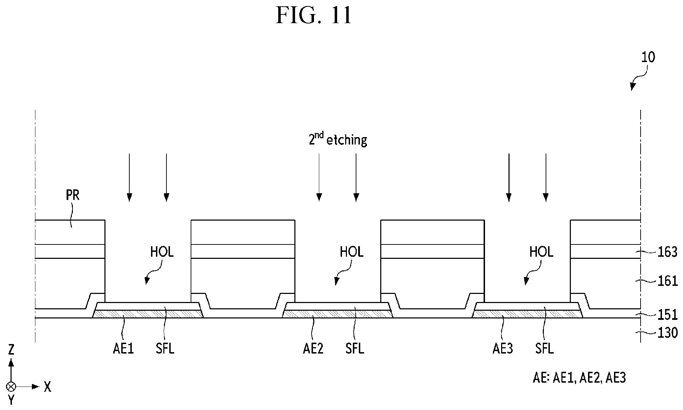

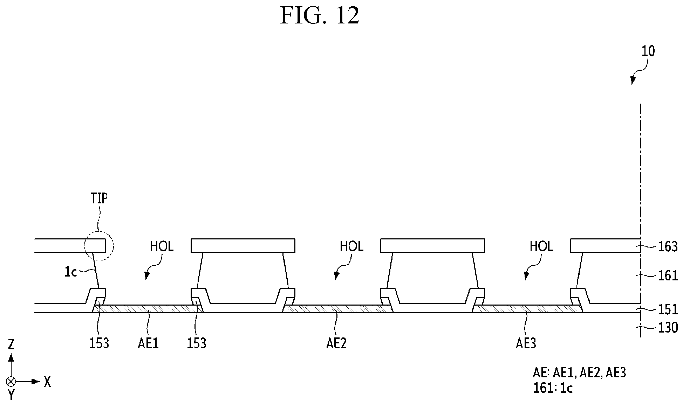

Subsequently, referring to FIG. 11 and FIG. 12, a plurality of photoresists PR including second photoresist patterns of a second photoresist layer is formed at the same locations as the photoresists PR used in the first etching process (1st etching), and a second etching process (2^{nd} etching) is performed. For example, the second etching process (2^{nd} etching) may be performed as a wet etching process.

In this process, the first bank layer 161 and the second bank layer 163 forming a bank of a bank layer and including different metal materials may have different etch selectivities. In other words, the etch rate of the first bank layer 161 may be higher than the etch rate of the second bank layer 163 in the same process. Accordingly, the second bank layer 163 which is second-etched may include tips TIP which protrude toward the holes HOL and further from the side surface 1c of the first bank layer 161.

In this process (e.g., the second etching process), parts of the sacrificial layer SFL which are exposed to outside the stacked structure at the holes HOL may be removed, and the anode electrodes AE may be exposed at the holes HOL. A part of the sacrificial layer SFL which is not removed in this process may remain as a residual pattern 153. The redundant descriptions will be omitted.

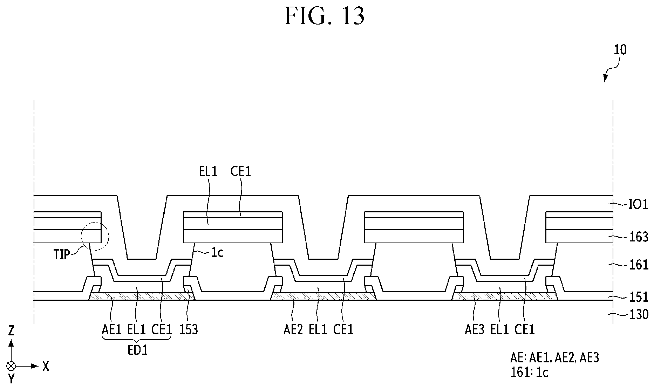

Subsequently, referring to FIGS. 13 to 15, a first emissive layer EL1, a first cathode electrode CE1 and a first element inorganic layer IO1 are deposited on the first anode electrode AE1, thereby forming the first emission structure ES1 shown in FIG. 4.

In this process, the first emissive layer EL1 may be formed via a thermal deposition process. The process of forming the first emissive layer EL1 may be performed without using a separate fine metal mask. For example, the process of forming the first emissive layer EL1 may be performed at an angle of about 45 degrees (°) to about 50° relative to the upper surface of the anode electrodes AE.

In this process, the material (e.g., a first emissive material layer) for forming the first emissive layer EL1 may be formed not only on the first anode electrode AE1 but also on the second anode electrode AE2, the third anode electrode AE3 and the second bank layer 163. In addition, the material for forming the first emissive layer EL1 may also be formed on the side surface 1c of the first bank layer 161.

In this process, the material for forming the first emissive layer EL1 formed on the anode electrodes AE and the material for forming the first emissive layer EL1 formed on the second bank layer 163 may be spaced apart from (or disconnected from) each other by the tips TIP of the second bank layer 163.

In this process, the first cathode electrode CE1 may be formed via a thermal deposition process or a sputtering deposition process. The process of forming the first cathode electrode CE1 may be performed without a separate fine metal mask and can have a higher step coverage than the deposition process of forming the first emissive layer EL1. Accordingly, the material for forming the first cathode electrode CE1 may entirely cover the material for forming the first emissive layer EL1.

In this process, the material (e.g., a first cathode material layer) for forming the first cathode electrode CE1 may be formed not only on the first anode electrode AE1 but also on the second anode electrode AE2, the third anode electrode AE3 and the second bank layer 163. In addition, the material for forming the first cathode electrode CE1 may also be formed on the side surface 1c of the first bank layer 161. The material for forming the first cathode electrode CE1 may entirely cover the first emissive layer EL1.

In this process, the material for forming the first cathode layer CE1 formed on the anode electrodes AE and the material for forming the first cathode electrode CE1 formed on the second bank layer 163 may be spaced apart from each other by the tips TIP of the second bank layer 163.

Subsequently, a first element inorganic layer IO1 is formed on the first light-emitting element ED1. The first element inorganic layer IO1 may be formed on the entire surface. For example, in this process, the material (e.g., a first inorganic material layer) for forming the first element inorganic layer IO1 may be formed not only on the first light-emitting element ED1, but also on the second anode electrode AE2, the third anode electrode AE3 and the second bank layer 163.

Subsequently, a photoresist PR including third photoresist patterns of a third photoresist layer is formed on the first anode electrode AE1 and the periphery of the stacked structure which is adjacent to the first anode electrode AE1, and a third etching process (3^{rd} etching) is performed using the photoresist PR as a mask. For example, the third etching process may be a dry etching process.

In this process, portions of the material for forming the first emissive layer EL1, the material for forming the first cathode electrode CE1 and the material for forming the first element inorganic layer IO1 not overlapping with the photoresists PR can be removed all at once.

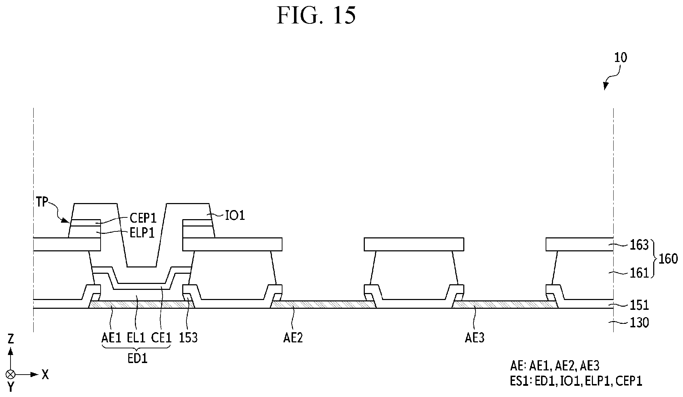

Accordingly, the material for forming the first emissive layer EL1 located on the second bank layer 163 surrounding the first emission area EA1 may be formed as a first organic pattern ELP1, the material for forming the first cathode electrode CE1 which surrounds the first emission area EA1 may be formed as a first electrode pattern CEP1, and the material for forming the first element inorganic layer IO1 which overlaps the first emission area EA1 and an area adjacent thereto may be formed as shown in FIG. 15.

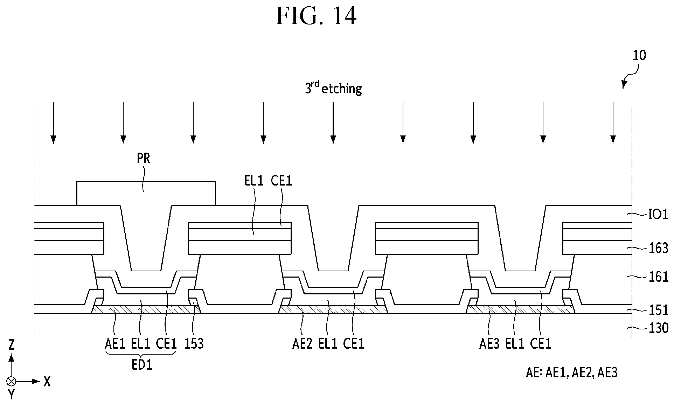

Referring to FIG. 14 and FIG. 15, while material portions respectively forming the patterns of the first emission structure ES1 which overlap the first emission area EA1 (or the second opening OP2) and overlap the area adjacent thereto are maintained on the substrate 110, remaining material portions are removed by the third etching process. In this process, the second anode electrode AE2 and the third anode electrode AE3 may be exposed again to outside the bank layer.

In this process, the first organic pattern ELP1, the first electrode pattern CEP1 and the first element inorganic layer IO1 may include a trench portion TP. In other words, the trench portion TP of the first organic pattern ELP1, the first electrode pattern CEP1 and the first element inorganic layer IO1 may mean that the first organic pattern ELP1, the first electrode pattern CEP1 and the first element inorganic layer IO1 are partially removed by the same etching process.

In this manner, the first emission structure ES1 can be formed.

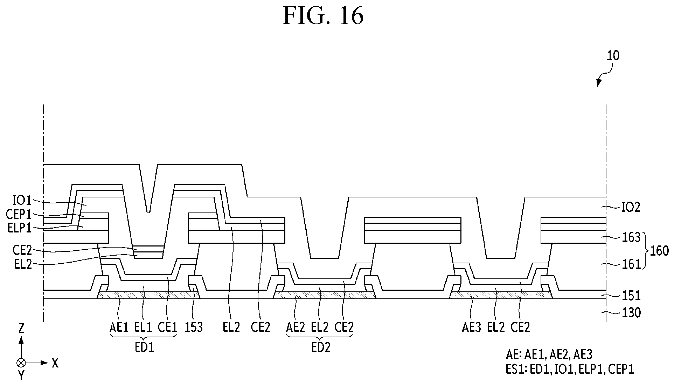

Subsequently, referring to FIGS. 16 to 18 together with the processes in FIGS. 13 to 15, a second emissive layer EL2, a second cathode electrode CE2 and a second element inorganic layer IO2 are provided on the second anode electrode AE2, thereby forming the second emission structure ES2 shown in FIG. 4.

In this process, the second emissive layer EL2 and the second cathode electrode CE2 may be formed by the same processes as the process of forming the first emissive layer EL1 and the process of forming the first cathode electrode CE1. It should be noted that the height of the second emissive layer EL2 may be different from the height of the first emissive layer EL1. The redundant descriptions will be omitted.

In this process, the material for forming the second emissive layer EL2 and the material for forming the second cathode electrode CE2 may be formed not only on the second anode electrode AE2 but also on the first anode electrode AE1, the third anode electrode AE3 and on the second bank layer 163. In this process, the material for forming the second emissive layer EL2 and the material for forming the second cathode electrode CE2 may be formed to cover the first emission structure ES1 as a previous emission structure. In this manner, the second light-emitting element ED2 can be formed.

Subsequently, a second element inorganic layer IO2 is formed on the second light-emitting element ED2. According to the embodiment, the second element inorganic layer IO2 may be formed on the entire surface. In this process, the height of the second element inorganic layer IO2 may be different from the height of the first element inorganic layer IO1. The redundant descriptions will be omitted.

In this process, the material for forming the second element inorganic layer IO2 may be formed not only on the second light-emitting element ED2, but also on the first anode electrode AE1, the third anode electrode AE3 and on the second bank layer 163. In addition, the material for forming the second element inorganic layer IO2 may be formed to cover the first emission structure ES1.

Subsequently, a photoresist PR is formed on the second anode electrode AE2 and the periphery of the second anode electrode AE2, and a third etching process (3^{rd} etching) is performed using the photoresist PR as a mask.

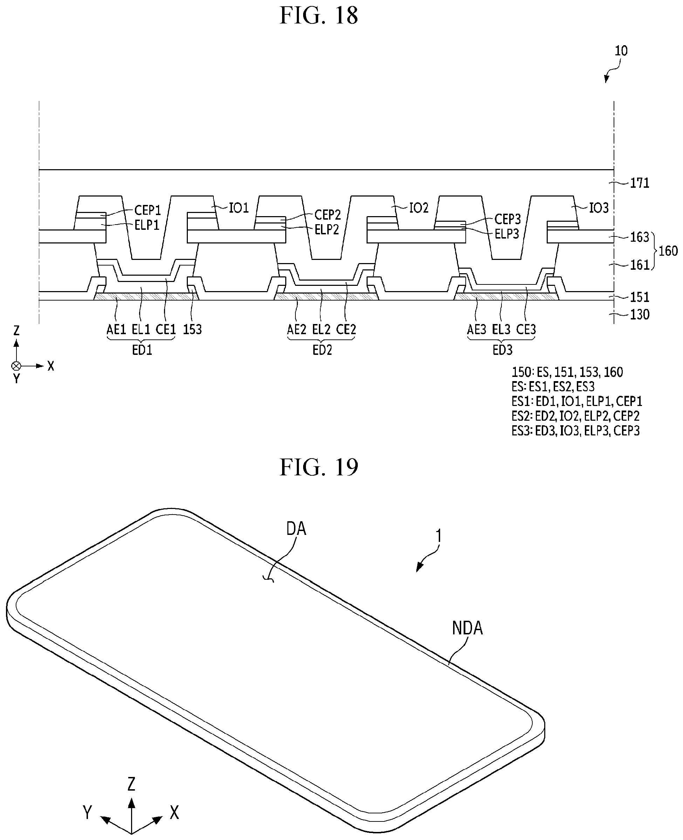

In this process, portions of the material for forming the second emissive layer EL2, the material for forming the second cathode electrode CE2 and the material for forming the second element inorganic layer IO2 not overlapping with the photoresists PR can be removed all at once. In this process, the material for forming the second emissive layer EL2 located on the second bank layer 163 may be formed as a second organic pattern ELP2, the material for forming the second cathode electrode CE2 may be formed as a second electrode pattern CEP2, and the material for forming the second element inorganic layer IO2 may be formed as shown in FIG. 18. In this manner, the second emission structure ES2 can be formed overlapping the second emission area EA2 and the area adjacent thereto.

Subsequently, a third emissive layer EL3, a third cathode electrode CE3 and a third element inorganic layer IO3 are formed on the third anode electrode AE3 by repeating the same processes described above. In these processes, the height of the third emissive layer EL3 may be different from the height of the first emissive layer EL1 and the height of the second emissive layer EL2. Accordingly, the height of the third element inorganic layer IO3 may be different from the height of the second element inorganic layer IO2 and the height of the first element inorganic layer IO1. The redundant descriptions will be omitted.

In this process, the material for forming the third emissive layer EL3 overlapping with the bank structure 160 may be formed as a third organic pattern ELP3, the material for forming the third cathode electrode CE3 may be formed as a third electrode pattern CEP3, and the material for forming the third element inorganic layer IO3 may be formed as shown in FIG. 18. In this manner, the third emission structure ES3 can be formed.

In this manner, the display element layer 150 shown in FIG. 4 can be formed. In the display device 10 according to the embodiment, the first emission structure ES1, the second emission structure ES2 and the third emission structure ES3 may have the same height with respect to a reference, such as the substrate 110. Therefore, the display element layer 150 according to the embodiment may include a uniform level to essentially provide a flat upper surface along which a subsequent layer can be provided. Accordingly, in the display device 10 according to the embodiment, an organic encapsulation material for providing the organic encapsulation layer 171 can spread evenly along the display element layer 150, in a subsequent process in the method of providing the display device 10. The redundant descriptions will be omitted.

In an embodiment, a display device 10 includes an emission area EA and a non-emission area NLA, a pixel-defining layer 151 in which first openings OP1 are defined corresponding to the emission area EA of the display device 10, a bank (e.g., the bank structure 160) on the pixel-defining layer 151 and in which second openings OP2 are defined respectively overlapping the first openings OP1, the bank including a first bank layer 161 and a second bank layer 163 in the non-emission area NLA, light emission structures ES respectively in the first openings OP1, including a first emission structure ES1 including a first light-emitting element ED1 and a first element inorganic pattern (e.g., the first element inorganic layer IO1) which covers the first light-emitting element ED1, a second emission structure ES2 spaced apart from the first emission structure ES1 in a direction along the pixel-defining layer 151, the second emission structure ES2 including a second light-emitting element ED2 and a second element inorganic pattern (e.g., the second element inorganic layer IO2) which covers the second light-emitting element ED2, each of the first element inorganic pattern and the second element inorganic pattern has a thickness in a respective first opening OP1 among the first openings OP1, the thickness of the first element inorganic pattern being different from the thickness of the second element inorganic pattern, and a total height of the first emission structure ES1 is equal to a total height of the second emission structure ES2, and an organic encapsulation layer 171 on the light emission structures ES.

The thickness of the first element inorganic pattern which is in the respective first opening OP1 may be lower than the thickness of the second element inorganic pattern which is in the respective first opening OP1. The thickness of the first element inorganic pattern which is in the respective first opening OP1 and the thickness of the second element inorganic pattern which is in the respective first opening OP1 may be about 1.05 micrometers to about 1.15 micrometers.

Relative to gas, a porosity of the first element inorganic pattern may be higher than a porosity of the second element inorganic pattern. A moisture permeability of the first element inorganic pattern may be equal to a moisture permeability of the second element inorganic pattern.

The light emission structures may further include a third emission structure ES3 spaced apart from the second emission structure ES2 in the direction along the pixel-defining layer 151 (e.g., in a planar direction along the X-Y plane), the third emission structure ES3 including a third light-emitting element ED3 and a third element inorganic pattern (e.g., the third element inorganic layer IO3) which covers the third light-emitting element ED3, and a total height of the third emission structure ES3 being equal to the total heights of the first emission structure ES1 and the second emission structure ES2. Relative to the pixel-defining layer 151, the total height of the third element inorganic pattern may be greater than the total height of the first element inorganic pattern and the total height of the second element inorganic pattern.

Within respective total heights of the first emission structure ES1 and the second emission structure ES2, the first light-emitting element ED1 may include a first emissive layer EL1 and a first cathode electrode CE1, the second light-emitting element ED2 may include a second emissive layer EL2 and a second cathode electrode CE2, and a thickness of the first emissive layer EL1 may be different from a thickness of the second emissive layer EL2. The thickness of the first emissive layer EL1 may be greater than the thickness of the second emissive layer EL2.

Within the respective total heights of the first emission structure ES1 and the second emission structure ES2, the first emission structure ES1 may further include a first emissive material layer (e.g., EL1 and ELP1) including the first emissive layer EL1 and a first organic pattern ELP1 which is on the second bank layer 163, the second emission structure ES2 may further include a second emissive material layer (e.g., EL2 and ELP2) including the second emissive layer EL2 and a second organic pattern ELP2 which is on the second bank layer 163, and a thickness of the first organic pattern ELP1 is greater than a thickness of the second organic pattern ELP2.

The first bank layer 161 may include a side surface (e.g., 1c) defining the second opening OP2, and the second bank layer 163 may protrude further than the side surface of the first bank layer 161 to define a tip TIP of the second bank layer 163 which overlaps the first opening OP1.

In an embodiment, an electronic device includes a display panel 100 including a display area DA and a non-display area NDA which is adjacent to the display area DA. The display area DA includes an emission area EA and a non-emission area NLA which is adjacent to the emission area EA, a pixel-defining layer 151 in which first openings OP1 are defined corresponding to the emission area EA of the display panel 100, a bank which is on the pixel-defining layer 151 and in which second openings OP2 are defined respectively overlapping the first openings OP1, the bank including a first bank layer 161 and a second bank layer 163 in the non-emission area NLA, light emission structures respectively in the first openings OP1, including a first emission structure ES1 including a first light-emitting element ED1 and a first element inorganic pattern layer which covers the first light-emitting element ED1, a second emission structure ES2 spaced apart from the first emission structure ES1 in a direction along the pixel-defining layer 151, the second emission structure ES2 including g a second light-emitting element ED2 and a second element inorganic pattern which covers the second light-emitting element ED2, each of the first element inorganic pattern and the second element inorganic pattern has a thickness in a respective first opening OP1 among the first openings OP1, the thickness of the first element inorganic pattern being different from the thickness of the second element inorganic pattern, and a total height of the first emission structure ES1 is equal to a total height of the second emission structure ES2, and an organic encapsulation layer 171 on the light emission structures.

In an embodiment, a method of providing a display device includes providing anode electrodes AE including a first anode electrode AE1 of a first light-emitting element ED1 and a second anode electrode AE2 of a second light-emitting element ED2 (see FIGS. 8 to 12), providing a bank layer (e.g., 160 and OP2) in which openings (e.g., the second openings OP2) are defined respectively exposing the anode electrodes AE to outside the bank layer (see FIG. 12), providing on the first anode electrode AE1 a first emission structure ES1 including a pattern (e.g., EL1) of the first light-emitting element ED1 and a first element inorganic pattern which covers the pattern, the providing including providing on an entirety of the anode electrodes AE and the bank layer, a material layer of the pattern of the first light-emitting element (e.g., a same material layer of the plurality of EL1 or the plurality of CE1 in FIG. 13) and a material layer of the first element inorganic pattern (e.g., the material layer of IO1 in FIG. 14), and etching the material layers of the first emission structure ES1 to provide the pattern (e.g., EL1) and the first element inorganic pattern (e.g., IO1) of the first emission structure ES1 and to expose the second anode electrode AE2 (see FIG. 15), and providing on the second anode electrode AE2 a second emission structure ES2 including a pattern of the second light-emitting element ED2 and a second element inorganic pattern which covers the pattern of the second light-emitting element ED2, the providing including providing on an entirety of the anode electrodes AE, the bank layer and the first emission structure ES1, a material layer of the pattern the second light-emitting element and a material layer of the second element inorganic pattern (e.g., repeating material layers for EL2, CE2 and IO2 as processed in FIGS. 13 and 14, for example), and etching the material layers of the second emission structure ES2 to provide the pattern and the second element inorganic pattern of the second emission structure ES2 and to expose the first emission structure ES1 to outside the second emission structure ES2 (see FIGS 16 to 18) A total height of the first emission structure ES1 is equal to a total height of the second emission structure ES2.

The pattern of the first emission structure ES1 may include a first emissive layer EL1 of the first light-emitting element ED1 which overlaps the first element inorganic pattern, the pattern of the second emission structure ES2 may include a second emissive layer EL2 of the second light-emitting element ED2 which overlaps the second element inorganic pattern. In the method, the providing of the first emissive layer EL1 and the second emissive layer EL2 may include a photo pattern process. A thickness of the first emissive layer EL1 may be greater than a thickness of the second emissive layer EL2, and a thickness of the first element inorganic pattern may be smaller than a thickness of the second element inorganic pattern.

In the method of providing a display device 10 (or of providing an electronic device 1 using the display device 10), the thickness of the first element inorganic pattern and the thickness of the second element inorganic pattern within the total heights of the first emission structure ES1 and the second emission structure ES2 may be directly related to the thickness of the first emissive layer EL1 and the thickness of the second emissive layer EL2, respectively.

FIG. 19 is a perspective view showing an electronic device 1 employing the display device 10 according to the embodiment of the present disclosure.

FIG. 19 shows a mobile electronic device employing the display device 10 according to the embodiment as an example of an electronic device 1. It should be noted that the display device 10 according to the embodiment can be applied to other electronic devices in addition to the mobile electronic device 1. For example, the display device 10 according to the embodiment may be employed by portable electronic devices such as a mobile phone which displays video or still images, a smart phone, a smart watch, a watch phone, a mobile communications terminal, an electronic notebook, an electronic book, a portable multimedia player (PMP), a navigation device, a ultra mobile PC (UMPC), and a tablet PC. Alternatively, the display device 10 according to the embodiment may be used as a display screen of a variety of electronic devices such as a television, a laptop computer, a monitor, an electronic billboard, and the Internet of Things (IOT).

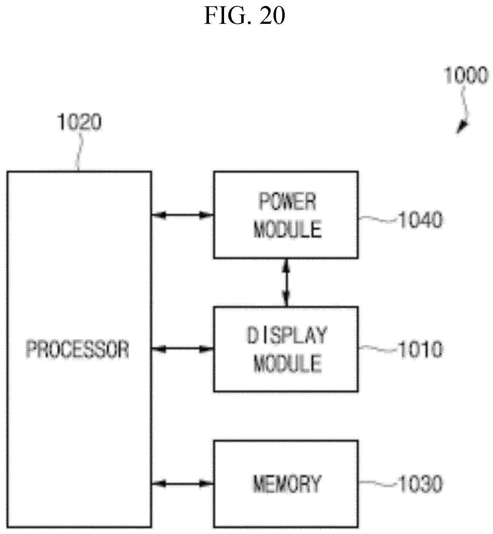

FIG. 20 is a block diagram illustrating an electronic device 1000 according to an embodiment of the present disclosure.

Referring to FIG. 20, an electronic device 1000 may include a display module 1010 (e.g., like the display device 10), a processor 1020, a memory 1030, and a power module 1040.

The processor 1020 may include at least one of a central processing unit (CPU), an application processor (AP), a graphic processing unit (GPU), a communication processor (CP), an image signal processor (ISP), and a controller.

The memory 1030 may store data information necessary for an operation of the processor 1020 or the display module 1010. When the processor 1020 executes an application stored in the memory 1030, an image data signal and/or an input control signal may be transmitted to the display module 1010, and the display module 1010 may process the received signal and output image information through a display screen.

The power module 1040 may include a power supply module such as a power adapter, a battery device, or the like and a power conversion module which converts power supplied by the power supply module to generate power necessary for an operation of the electronic device 1000.

At least one of the components of the electronic device 1000 described above may be included in the display device 10 according to embodiments described above. In addition, some of individual modules functionally included in one module may be included in the display device 10, and others may be provided separately from the display device 10. For example, the display device 10 may include the display module 1010, and the processor 1020, the memory 1030, and the power module 1040 may be provided in form of other devices in the electronic device 1000 other than the display device 10.

Although the embodiments of the present disclosure have been described with reference to the accompanying drawings, those skilled in the art would understand that various modifications and alterations may be made without departing from the technical idea or essential features of the present disclosure. Therefore, it should be understood that the above-mentioned embodiments are not limiting but illustrative in all aspects.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
an emission area and a non-emission area;
a pixel-defining layer in which first openings are defined corresponding to the emission area of the display device;
a bank which is on the pixel-defining layer and in which second openings are defined respectively overlapping the first openings, the bank comprising a first bank layer and a second bank layer in the non-emission area;
light emission structures respectively in the first openings, comprising:
a first emission structure comprising a first light-emitting element and a first element inorganic pattern which covers the first light-emitting element;
a second emission structure spaced apart from the first emission structure in a direction along the pixel-defining layer, the second emission structure comprising a second light-emitting element and a second element inorganic pattern which covers the second light-emitting element;
each of the first element inorganic pattern and the second element inorganic pattern has a thickness in a respective first opening among the first openings, the thickness of the first element inorganic pattern being different from the thickness of the second element inorganic pattern; and
a total height of the first emission structure is equal to a total height of the second emission structure; and
an organic encapsulation layer on the light emission structures.

2. The display device of claim 1, wherein the thickness of the first element inorganic pattern which is in the respective first opening is lower than the thickness of the second element inorganic pattern which is in the respective first opening.

3. The display device of claim 2, wherein relative to gas, a porosity of the first element inorganic pattern is higher than a porosity of the second element inorganic pattern.

4. The display device of claim 3, wherein the thickness of the first element inorganic pattern which is in the respective first opening and the thickness of the second element inorganic pattern which is in the respective first opening is about 1.05 micrometers to about 1.15 micrometers, optionally wherein a moisture permeability of the first element inorganic pattern is equal to a moisture permeability of the second element inorganic pattern.

5. The display device of any one of claims 1 to 4, wherein
the first element inorganic pattern comprises a first surface in contact with the organic encapsulation layer,
the second element inorganic pattern comprises a second surface in contact with the organic encapsulation layer, and
the first surface and the second surface are coplanar with each other.

6. The display device of claim 5, wherein the first surface and the second surface are spaced apart from each other at the non-emission area with a portion of the organic encapsulation layer therebetween.

7. The display device of claim 6, wherein the light emission structures further comprise:
a third emission structure spaced apart from the second emission structure in the direction along the pixel-defining layer, the third emission structure comprising a third light-emitting element and a third element inorganic pattern which covers the third light-emitting element, and
a total height of the third emission structure being equal to the total heights of the first emission structure and the second emission structure.

8. The display device of claim 7, wherein:
(i) relative to the pixel-defining layer, the total height of the third element inorganic pattern is greater than the total height of the first element inorganic pattern and the total height of the second element inorganic pattern; and/or
(ii) the third element inorganic pattern comprises a third surface in contact with the organic encapsulation layer, and
the first surface, the second surface and the third surface are coplanar with each other; and/or
(iii) the first emission structure, the second emission structure and the third emission structure emit light of different colors.

9. The display device of any one of claims 2 to 8, wherein within respective total heights of the first emission structure and the second emission structure:
the first light-emitting element comprises a first emissive layer and a first cathode electrode,
the second light-emitting element comprises a second emissive layer and a second cathode electrode, and
a thickness of the first emissive layer is different from a thickness of the second emissive layer.

10. The display device of claim 9, wherein the thickness of the first emissive layer is greater than the thickness of the second emissive layer, optionally wherein within the respective total heights of the first emission structure and the second emission structure:
the first emission structure further comprises a first emissive material layer including the first emissive layer and a first organic pattern which is on the second bank layer,
the second emission structure further comprises a second emissive material layer including the second emissive layer and a second organic pattern which is on the second bank layer, and
a thickness of the first organic pattern is greater than a thickness of the second organic pattern.

11. The display device of any one of claims 1 to 10, wherein
the first bank layer includes a side surface defining the second openings, and
the second bank layer protrudes further than the side surface of the first bank layer to define a tip of the second bank layer which overlaps the first opening.

12. An electronic device comprising:
a display panel comprising:
a display area and a non-display area which is adjacent to the display area, and
the display area comprising:
an emission area and a non-emission area which is adjacent to the emission area;
a pixel-defining layer in which first openings are defined corresponding to the emission area of the display panel;
a bank which is on the pixel-defining layer and in which second openings are defined respectively overlapping the first openings, the bank comprising a first bank layer and a second bank layer in the non-emission area;
light emission structures respectively in the first openings, comprising:
a first emission structure comprising a first light-emitting element and a first element inorganic pattern which covers the first light-emitting element;
a second emission structure spaced apart from the first emission structure in a direction along the pixel-defining layer, the second emission structure comprising a second light-emitting element and a second element inorganic pattern which covers the second light-emitting element;
each of the first element inorganic pattern and the second element inorganic pattern has a thickness in a respective first opening among the first openings, the thickness of the first element inorganic pattern being different from the thickness of the second element inorganic pattern; and
a total height of the first emission structure is equal to a total height of the second emission structure; and
an organic encapsulation layer on the light emission structures.

13. A method of providing a display device, the method comprising:
providing anode electrodes including a first anode electrode of a first light-emitting element and a second anode electrode of a second light-emitting element;
providing a bank layer in which openings are defined respectively exposing the anode electrodes to outside the bank layer;
providing on the first anode electrode a first emission structure including a pattern of the first light-emitting element and a first element inorganic pattern which covers the pattern, comprising:
providing on an entirety of the anode electrodes and the bank layer, a material layer of the pattern of the first light-emitting element and a material layer of the first element inorganic pattern, and
etching the material layers of the first emission structure to provide the pattern and the first element inorganic pattern of the first emission structure and to expose the second anode electrode; and
providing on the second anode electrode a second emission structure including a pattern of the second light-emitting element and a second element inorganic pattern which covers the pattern of the second light-emitting element, comprising:
providing on an entirety of the anode electrodes, the bank layer and the first emission structure, a material layer of the pattern the second light-emitting element and a material layer of the second element inorganic pattern, and
etching the material layers of the second emission structure to provide the pattern and the second element inorganic pattern of the second emission structure and to expose the first emission structure to outside the second emission structure,
wherein a total height of the first emission structure is equal to a total height of the second emission structure.

14. The method of claim 13, wherein
the pattern of the first emission structure comprises a first emissive layer of the first light-emitting element which overlaps the first element inorganic pattern,
the pattern of the second emission structure comprises a second emissive layer of the second light-emitting element which overlaps the second element inorganic pattern, and
providing of the first emissive layer and the second emissive layer comprises a photo pattern process.

15. The method of claim 14, wherein
a thickness of the first emissive layer is greater than a thickness of the second emissive layer, and
a thickness of the first element inorganic pattern is smaller than a thickness of the second element inorganic pattern, optionally wherein the thickness of the first element inorganic pattern and the thickness of the second element inorganic pattern within the total heights of the first emission structure and the second emission structure are directly related to the thickness of the first emissive layer and the thickness of the second emissive layer, respectively.
